# EUROPEAN PATENT SPECIFICATION

(11) **EP 2 347 898 B1**
(45) Date of publication and mention of the grant of the patent: **07.06.2017**
(21) Application number: 09818931.9
(22) Date of filing: 01.10.2009
(51) Int. Cl.: B32B 27/30, C03C 27/12, C08J 7/04

(54) **MULTILAYER BODY**
MEHRSCHICHTIGER KÖRPER
CORPS MULTICOUCHE

(30) Priority: 06.10.2008 JP 2008259213; 06.10.2008 JP 2008259214; 06.10.2008 JP 2008259215
(43) Date of publication of application: 27.07.2011
(73) Proprietor: Kuraray Co., Ltd., Okayama 710-0801 (JP)
(72) Inventor: ASANUMA, Yoshiaki, Kurashiki-shi Okayama 713-8550 (JP); ISOUE, Kouichiro, Kurashiki-shi Okayama 713-8550 (JP)
(74) Representative: Hoffmann Eitle
(86) International application number: PCT/JP2009/005086
(87) International publication number: WO 2010/041391

(56) References cited:
- WO-A1-2005/118653
- JP-A- 2 038 432
- JP-A- 6 019 047
- JP-A- 63 230 336
- JP-A- 2001 106 556
- JP-A- 2003 040 653
- JP-A- 2007 162 020
- JP-T- 2007 513 813

## Description

### TECHNICAL FIELD

The present invention relates to a polyvinyl acetal-based laminate, and uses thereof.

### BACKGROUND ART

Polyvinyl acetals, which are represented by polyvinyl butyral, have excellent adhesiveness or compatibility to various organic and inorganic base materials, and excellent solubility in organic solvents, and therefore, polyvinyl acetals are widely used in various adhesives or binders for ceramics, various inks and coating materials, or intermediate film for safety glass. In connection with these uses, investigations have been carried out under the aim of imparting new and improved functions by using laminates of a layer containing polyvinyl acetal with another resin layer or resin sheet. However, depending on the type of the resin layer or resin sheet to be laminated, the interlayer adhesive power between the layer containing polyvinyl acetal and those layers may not be sufficient in all cases. Thus, an investigation is being conducted on the interlayer adhesives to be used in the case of laminating those layers. For example, several interlayer adhesives are being investigated for the case where a polyester film is laminated to an intermediate film for safety glass in order to increase the strength of the intermediate film.

Investigations have been conducted on bonding a polyvinyl acetal layer with a polyester layer, using a silane coupling agent having an amino group, for example, 3-aminopropyltriethoxysilane or 3-(2-aminoethyl)propyltriethoxysilane, as an interlayer adhesive (see, for example, Patent Documents 1 to 3). However, when primary or secondary amino group-containing silane coupling agents such as mentioned above are used, these silane coupling agents may cause problems such as yellowing on a long-term use, or clouding of the polyvinyl acetal layer due to moisture absorption. Furthermore, there have been occasions where the primary or secondary amino groups undergo a reaction with polyvinyl acetal or additives, and cause yellowing on a long-term use or a decrease in adhesiveness. Furthermore, the alkoxysilyl groups contained in the silane coupling agents such as mentioned above easily undergo hydrolysis, and the silanol groups produced therefrom are prone to cause problems such as generation of gel matter due to a condensation reaction. Accordingly, the actual production processes may require additional steps such as filtering of the gel matter generated from a silane coupling agent, or regulating the hydrogen ion concentration of the composition containing a silane coupling agent so as to prevent the occurrence of a hydrolysis reaction.

### PRIOR ART DOCUMENTS

### PATENT DOCUMENTS

Patent Document 1: Japanese Patent Application Laid-Open (JP-A) No. 2001-106556
Patent Document 2: JP-A No. 1998-194796
Patent Document 3: Japanese Patent Application Publication (JP-B) No. 1995-68054

### DISCLOSURE OF THE INVENTION

### PROBLEM TO BE SOLVED BY THE INVENTION

It is a purpose of the present invention to provide a laminate which does not undergo changes over time in the properties even during a long-term use, and is excellent in the interlayer adhesiveness, strength and transparency.

### MEANS FOR SOLVING PROBLEM

Above-mentioned purpose is accomplished by a laminate according to claim 1 which comprises a polyvinyl acetal layer (layer A) and a resin layer (layer B), the laminate comprising an adhesive layer (layer C) containing a polymer having an amino group between the layer A and the layer B. And also, above-mentioned purpose is accomplished by a laminate according to claim 2 which comprises a polyvinyl acetal layer (layer A) and a resin layer (layer B), wherein at least one of the layer A and the layer B contains a polymer having an amino group.

Above-mentioned purpose is accomplished by a laminate which comprises the polyvinyl acetal layer (layer A) and the resin layer (layer B), the laminate comprising the adhesive layer (layer C) contains a polymer of a compound having a tertiary amino group and an ethylenically unsaturated bond, and a compound having an alkoxysilyl group between the layer A and the layer B. And also, above-mentioned purpose is accomplished by a laminate which comprises the polyvinyl acetal layer (layer A) and the resin layer (layer B), wherein at least one of the layer A and the layer B contains a polymer of a compound having a tertiary amino group and an ethylenically unsaturated bond, and a compound having an alkoxysilyl group.

Above-mentioned purpose is accomplished by a laminate which comprises the polyvinyl acetal layer (layer A) and the resin layer (layer B), the laminate comprising the adhesive layer (layer C) containing a polymer of a compound having a tertiary amino group and an ethylenically unsaturated bond, and a polymer of a compound having an alkoxysilyl group and an ethylenically unsaturated bond between the layer A and the layer B. And also, above-mentioned purpose is accomplished by a laminate which comprises the polyvinyl acetal layer (layer A) and the resin layer (layer B), wherein at least one of the layer A and the layer B contains a polymer of a compound having a tertiary amino group and an ethylenically unsaturated bond, and a polymer of a compound having an alkoxysilyl group and an ethylenically unsaturated bond.

Above-mentioned purpose is accomplished by a laminate which comprises the polyvinyl acetal layer (layer A) and the resin layer (layer B), the laminate comprising the adhesive layer (layer C) containing a copolymer of a compound having a tertiary amino group and an ethylenically unsaturated bond and a compound having an alkoxysilyl group and an ethylenically unsaturated bond between the layer A and the layer B. And also, above-mentioned purpose is accomplished by a laminate which comprises the polyvinyl acetal layer (layer A) and the resin layer (layer B), wherein at least one of the layer A and the layer B contains a copolymer of a compound having a tertiary amino group and an ethylenically unsaturated bond and a compound having an alkoxysilyl group and an ethylenically unsaturated bond.

Above-mentioned purpose is accomplished by a laminate which comprises the polyvinyl acetal layer (layer A) and the resin layer (layer B), the laminate comprising the adhesive layer (layer C) containing a polymer having an oxazoline group between the layer A and the layer B. And also, above-mentioned purpose is accomplished by a laminate which comprises the polyvinyl acetal layer (layer A) and the resin layer (layer B), wherein at least one of the layer A and the layer B contains a polymer having an oxazoline group.

Further disclosed herein is a method for producing a laminate, the method comprising forming an adhesive layer (layer C) containing a polymer having an amino group, on the surface of at least one of a polyvinyl acetal layer (layer A) and a resin layer (layer B), adhering the surfaces, and thereby laminating the polyvinyl acetal layer (layer A) and the resin layer (layer B). And also, above-mentioned purpose is accomplished by a method for producing a laminate, wherein a polymer having an amino group is added to at least one of a polyvinyl acetal layer (layer A) and a resin layer (layer B), and the polyvinyl acetal layer (layer A) and the resin layer (layer B) are laminated.

Further disclosed herein isa method for producing a laminate, wherein the adhesive layer (layer C) is formed by applying, on the surface of at least one of the polyvinyl acetal layer (layer A) and the resin layer (layer B), an application liquid containing a compound having a tertiary amino group and an ethylenically unsaturated bond, a compound having an alkoxysilyl group, and a polymerization initiator, and after or during the drying of the application liquid, polymerizing the compound having a tertiary amino group and an ethylenically unsaturated bond. And also, above-mentioned purpose is accomplished by a method for producing a laminate, wherein a polymer of a compound having a tertiary amino group and an ethylenically unsaturated bond, and a compound having an alkoxysilyl group are added to at least one of the polyvinyl acetal layer (layer A) and the resin layer (layer B), and the polyvinyl acetal layer (layer A) and the resin layer (layer B) are laminated.

Further disclosed herein isa method for producing a laminate, wherein the adhesive layer (layer C) is formed by applying, on the surface of at least one of the polyvinyl acetal layer (layer A) and the resin layer (layer B), an application liquid containing a polymer of a compound having a tertiary amino group and an ethylenically unsaturated bond, a compound having an alkoxysilyl group and an ethylenically unsaturated bond, and a polymerization initiator, and after or during the drying of the application liquid, polymerizing the compound having an alkoxysilyl group and an ethylenically unsaturated bond. And also, above-mentioned purpose is accomplished by a method for producing a laminate, wherein a polymer of a compound having a tertiary amino group and an ethylenically unsaturated bond, and a polymer of a compound having an alkoxysilyl group and an ethylenically unsaturated bond, are added to at least one of the polyvinyl acetal layer (layer A) and the resin layer (layer B), and the polyvinyl acetal layer (layer A) and the resin layer (layer B) are laminated.

Further disclosed herein isa method for producing a laminate, wherein the adhesive layer (layer C) is formed by applying, on the surface of at least one of the polyvinyl acetal layer (layer A) and the resin layer (layer B), an application liquid containing a compound having a tertiary amino group and an ethylenically unsaturated bond, a compound having an alkoxysilyl group and an ethylenically unsaturated bond, and a polymerization initiator, and after or during the drying of the application liquid, copolymerizing the compound having a tertiary amino group and an ethylenically unsaturated bond, and the compound having an alkoxysilyl group and an ethylenically unsaturated bond. And also, above-mentioned purpose is accomplished by a method for producing a laminate, wherein a copolymer of a compound having a tertiary amino group and an ethylenically unsaturated bond and a compound having an alkoxysilyl group and an ethylenically unsaturated bond, is added to at least one of the polyvinyl acetal layer (layer A) and the resin layer (layer B), and the polyvinyl acetal layer (layer A) and the resin layer (layer B) are laminated.

Further disclosed herein isa method for producing a laminate, wherein the adhesive layer (layer C) is formed by applying an application liquid containing a polymer having an oxazoline group on the surface of at least one of the polyvinyl acetal layer (layer A) and the resin layer (layer B), and drying the application liquid. And also, above-mentioned purpose is accomplished by a method for producing a laminate, wherein a polymer having an oxazoline group is added to at least one of the polyvinyl acetal layer (layer A) and the resin layer (layer B), and the polyvinyl acetal layer (layer A) and the resin layer (layer B) are laminated.

### EFFECT OF THE INVENTION

The laminate of the present invention does not undergo changes over time in the properties even during a long-term use, and is excellent in the interlayer adhesiveness, strength and transparency. Therefore, the laminate of the present invention is suitably used in the applications involving lamination of a polyvinyl acetal layer (layer A) and various resin layers (layer B), for example, intermediate film for laminated glass, solar cell modules, inkjet recording materials, and sublimation type ink ribbons. Particularly, the laminate of the present invention exhibits excellent effects in intermediate film for laminated glass, and in solar cell modules.

### BRIEF DESCRIPTION OF THE DRAWINGS

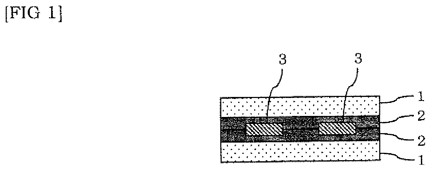

FIG. 1 is a schematic diagram of a solar cell module having crystalline silicon sealed therein.

### BEST MODES FOR CARRYING OUT THE INVENTION

First, a compound having a tertiary amino group and an ethylenically unsaturated bond, which serves as a raw material of a polymer of a compound having a tertiary amino group and an ethylenically unsaturated bond used in the present invention, will be described. The tertiary amino group that is contained in the compound used in the present invention may be any of an aliphatic tertiary amine and an aromatic tertiary amine.

There are no particular limitations on the group having an ethylenically unsaturated bond, but a group selected from an acryloyl group which may be substituted with a hydrocarbon substituent having 1 to 10 carbon atoms and a vinyl group which may be substituted with a hydrocarbon substituent having 1 to 10 carbon atoms, is suitable. Here, the acryloyl group which may be substituted with a hydrocarbon substituent having 1 to 10 carbon atoms, refers to an acryloyl group, or a group obtained by substituting one or more hydrogen atoms of an acryloyl group with hydrocarbon groups having 1 to 10 carbon atoms. Furthermore, a vinyl group which may be substituted with a hydrocarbon substituent having 1 to 10 carbon atoms, refers to a vinyl group, or a functional group obtained by substituting one or more hydrogen atoms of a vinyl group with hydrocarbon groups having 1 to 10 carbon atoms. For any of these cases, there are no particular limitations on the hydrocarbon group having 1 to 10 carbon atoms, and examples thereof include a methyl group, an ethyl group, a propyl group, an isopropyl group, a butyl group, a hexyl group, an octyl group, a decyl group, a phenyl group, and a tolyl group. If the hydrocarbon substituent of the acryloyl group which may be substituted with a hydrocarbon substituent or the vinyl group which may be substituted with a hydrocarbon substituent, has more than 10 carbon atoms, the interlayer adhesiveness between the layer A and the layer B may be insufficient, which is not preferable.

Specific examples of the compound having a tertiary amino group and an ethylenically unsaturated bond include dimethylaminoethyl (meth)acrylate, diethylaminoethyl (meth)acrylate, dimethylaminopropyl (meth)acrylate, dimethylaminobutyl (meth)acrylate, 2-vinylpyridine, 3-vinylpyridine, 4-vinylpyridine, 4-(1-propenyl)pyridine, 2-dimethylaminostyrene, 3-dimethylaminostyrene, 4-dimethylaminostyrene, 1-(4-dimethylamino)propene, dimethylvinylamine, allyldimethylamine, dimethyl(1-propenyl)amine, diallylmethylamine, triallylamine, and N-vinylpiperidine. When these compounds are polymerized by a method that will be described below, a polymer of the compound having a tertiary amino group and an ethylenically unsaturated bond used in the present invention is obtained. Among them, dimethylaminoethyl (meth)acrylate, diethylaminoethyl (meth)acrylate, and 4-vinylpyridine are preferred, from the viewpoints that the interlayer adhesiveness is excellent, and the compounds are easily available.

Next, the compound having an alkoxysilyl group that is used in the present invention will be explained. An alkoxysilyl group is a functional group formed by direct bonding of silicon and alkoxy group. An alkoxysilyl group can be hydrolyzed by the moisture in air to form a silanol group (Si-OH), and can form a strong interaction (hydrogen bonding) with a hydroxyl group of polyvinyl acetal and with a polar functional group contained in the resin layer (layer B).

There are no particular limitations on the alkoxy group, and examples thereof include a methoxy group, an ethoxy group, a propoxy group, an isopropoxy group, a methoxyethoxy group, an acetoxy group, and a phenoxy group. Furthermore, examples of alkoxysilyl groups containing these alkoxy groups include a trialkoxysilyl group; a dialkoxysilyl group obtained by substituting one alkoxy group of a trialkoxysilyl group with a hydrocarbon group having 1 to 10 carbon atoms; and a monoalkoxysilyl group obtained by substituting two alkoxy groups of a trialkoxysilyl group with hydrocarbon groups each having 1 to 10 carbon atoms. There are no particular limitations on the hydrocarbon group having 1 to 10 carbon atoms, and examples thereof include a methyl group, an ethyl group, a propyl group, an isopropyl group, a butyl group, a hexyl group, an octyl group, a decyl group, a phenyl group, and a tolyl group.

Specific examples of the compound having an alkoxysilyl group that is used in the present invention, include methyltrimethoxysilane, methyltriethoxysilane, methyltripropoxysilane, methyltriisopropoxysilane, methyltributoxysilane, methyltriphenoxysilane, methyltriacetoxysilane, methyltri(methoxyethoxy)silane, dimethyldimethoxysilane, trimethylmethoxysilane, ethyltrimethoxysilane, propyltrimethoxysilane, isopropyltrimethoxysilane, butyltrimethoxysilane, hexyltrimethoxysilane, octyltrimethoxysilane, 2-ethylhexyltrimethoxysilane, decyltrimethoxysilane, phenyltrimethoxysilane, and 3-mercaptopropyltrimethoxysilane. Among them, methyltrimethoxysilane and butyltrimethoxysilane are preferred, from the viewpoint of interlayer adhesiveness. Furthermore, examples of the compound simultaneously having an alkoxysilyl group and an ethylenically unsaturated bond include vinyltrimethoxysilane, vinyltriethoxysilane, vinyltripropoxysilane, vinyltriisopropoxysilane, vinyltributoxysilane, vinyltriphenoxysilane, vinyltriacetoxysilane, vinyltri(methoxyethoxy)silane, allyltrimethoxysilane, 3-methacryloyloxypropyltrimethoxysilane, 3-methacryloyloxypropyltriethoxysilane, 3-methacryloyloxypropyltriisopropoxysilane, and 3-acryloyloxypropyltriethoxysilane. Among them, 3-methacryloyloxypropyltrimethoxysilane is preferred from the viewpoint of interlayer adhesiveness.

A polymer which is obtained by polymerizing the said compound having an alkoxysilyl group and an ethylenically unsaturated bond, by a method that will be described below, can be used for the laminate of the present invention. This polymer may be used together with the compound having an alkoxysilyl group mentioned above. When this polymer is used in the laminate of the present invention, improved interlayer adhesiveness is exhibited.

Furthermore, a copolymer of a compound having a tertiary amino group and an ethylenically unsaturated bond, and a compound having an alkoxysilyl group and an ethylenically unsaturated bond, can also be used for the laminate of the present invention. This copolymer is obtained by, for example, copolymerizing the compound having a tertiary amino group and an ethylenically unsaturated bond, with the compound having an alkoxysilyl group and ethylenically unsaturated bond, by a method that will be described below. There are no particular limitations on the mass ratio of (compound having a tertiary amino group and an ethylenically unsaturated bond)/(compound having an alkoxysilyl group and an ethylenically unsaturated bond) in this copolymer, but the mass ratio is preferably 0.1/99.9 to 99.9/0.1, more preferably 1/99 to 99/1, and even more preferably 5/95 to 95/5. In addition, this copolymer may be used together with a polymer of a compound having a tertiary amino group and an ethylenically unsaturated bond, or with a polymer of a compound having an alkoxysilyl group and an ethylenically unsaturated bond.

The polymer of a compound having a tertiary amino group and an ethylenically unsaturated bond, the polymer of a compound having an alkoxysilyl group and an ethylenically unsaturated bond, and the copolymer of a compound having a tertiary amino group and an ethylenically unsaturated bond and a compound having an alkoxysilyl group and an ethylenically unsaturated bond (hereinafter, these may be collectively referred to as adhesive polymers) are obtained by polymerizing the respective corresponding monomer compounds by conventionally known methods such as a solution polymerization method, a bulk polymerization method, a suspension polymerization method and an emulsion polymerization method, if necessary, through a heat treatment or light irradiation in the presence of a polymerization initiator. There are no particular limitations on the polymerization initiator, but suitable examples include a polymerization initiator of the type that is decomposed by a heat treatment or light irradiation and polymerizes a radical generated therefrom as an active species, and a polymerization initiator of the type that allows polymerization to proceed using an anionic species as an active species. Examples of the polymerization initiator that is decomposed by a heat treatment and generates a radical, include acyloyl peroxides such as benzoyl peroxide and lauroyl peroxide; alkyl peracid esters such as cumene hydroperoxide, t-butyl perbenzoate, and i-propyl peracetate; dialkyl peroxide such as di-t-butyl peroxide; and azo compounds such as azobisisobutyronitrile, azobiscyclohexanecarbonitrile, and 2,2-azobis-2,4-dimethylvaleronitrile. Examples of the polymerization initiator that generates a radical by light irradiation, include benzophenone, 2-hydroxy-4'-(2-hydroxyethoxy)-2-methylpropiophenone, α,α-dimethoxy-α-morpholino-methylthiophenylacetophenone, 2,4,6-trimethylbenzoylphosphine oxide, thioxanthone, and tetramethylthiuram disulfide. Furthermore, examples of the polymerization initiator of the type that allows polymerization to proceed using an anionic species as an active species, include organolithium reagents such as n-butyllithium and phenyllithium; organoaluminum reagents such as triethylaluminum; organozinc reagents such as diethylzinc; and organomagnesium reagents (Grignard reagents) such as n-butylmagnesium bromide and n-butylmagnesium chloride. These initiators are appropriately selected depending on the type of the compound that is polymerized.

In the case of adding a compound having an alkoxysilyl group or the adhesive polymers described above (these may be collectively referred to as adhesive compounds), to at least one layer of the polyvinyl acetal layer (layer A) and the resin layer (layer B) in the laminate of the present invention, the amount of addition is not particularly limited, but the amount of the adhesive compound with respect to the mass of the layer A and/or layer B, to which the adhesive compound is to be added, is preferably 0.001% to 5% by mass, more preferably 0.005% to 3% by mass, and optimally 0.01% to 2% by mass. If the amount of the adhesive compound is less than 0.001% by mass, there is a possibility that sufficient interlayer adhesiveness may not be exhibited, and even if the amount is more than 5% by mass, any further special enhancement of interlayer adhesiveness cannot be expected.

Furthermore, in the case where the laminate of the present invention has an adhesive layer (layer C) containing the adhesive compound, a method of forming the adhesive layer (layer C) using the adhesive compound on the surface of a layer A and/or a layer B, and then laminating the layer A and the layer B; a method of separately producing a layer A, a layer B and a layer C, and then laminating the three layers; or the like may be used. There are no particular limitations on the content of the adhesive compound in the layer C, but the content is suitably 30% by mass or more, more suitably 80% by mass or more, and optimally 90% by mass or more. If the content is less than 30% by mass, sufficient interlayer adhesiveness may not be exhibited.

There are no particular limitations on the content ratio between the polymer of a compound having a tertiary amino group and an ethylenically unsaturated bond, and various other components, which are contained in the adhesive compound, but the ratio [(mass of the compound having a tertiary amino group and an ethylenically unsaturated bond introduced into the adhesive polymer) / (total mass of the mass of the compound having an alkoxysilyl group and an ethylenically unsaturated bond introduced into the adhesive polymer, and the mass of the compound having an alkoxysilyl group)] is suitably 99.9/0.1 to 0.1/99.9, more suitably 99/1 to 1/99, and optimally 95/5 to 5/95.

The adhesive polymer used in the present invention may be copolymerized with a compound other than those mentioned above, so long as the gist of the present invention is maintained. Specific examples of such a compound include α-olefins such as ethylene, propylene, n-butene, and isobutylene; acrylic acid and salts thereof; acrylic acid esters such as methyl acrylate, ethyl acrylate, n-propyl acrylate, i-propyl acrylate, n-butyl acrylate, i-butyl acrylate, t-butyl acrylate, 2-ethylhexyl acrylate, dodecyl acrylate, and octadecyl acrylate; methacrylic acid and salts thereof; methacrylic acid esters such as methyl methacrylate, ethyl methacrylate, n-propyl methacrylate, i-propyl methacrylate, n-butyl methacrylate, i-butyl methacrylate, t-butyl methacrylate, 2-ethylhexyl methacrylate, dodecyl methacrylate, and octadecyl methacrylate; acrylamide derivatives such as acrylamide, N-methylacrylamide, N-ethylacrylamide, N,N-dimethylacrylamide, diacetone acrylamide, acrylamidopropanesulfonic acid and salts thereof, and N-methylolacrylamide and derivatives thereof; methacrylamide derivatives such as methacrylamide, N-methylmethacrylamide, N-ethylmethacrylamide, methacrylamidopropanesulfonic acid and salts thereof, and N-methylolmethacrylamide and derivatives thereof; vinyl ethers such as methyl vinyl ether, ethyl vinyl ether, n-propyl vinyl ether, i-propyl vinyl ether, n-butyl vinyl ether, i-butyl vinyl ether, t-butyl vinyl ether, dodecyl vinyl ether, and stearyl vinyl ether; nitriles such as acrylonitrile, and methacrylonitrile; vinyl halides such as vinyl chloride and vinyl fluoride; vinylidene halides such as vinylidene chloride and vinylidene fluoride; allyl compounds such as allyl acetate and allyl chloride; maleic acid and salts thereof, esters thereof or anhydrides thereof; vinylsilyl compounds such as vinyltrimethoxysilane; and isopropenyl acetate. There are no particular limitations on the amount of introduction of these compounds in the adhesive polymer, but the amount of introduction is suitably 10% by mole or less relative to the amounts of introduction of the compound having a tertiary amino group and an ethylenically unsaturated bond and the compound having an alkoxysilyl group and an ethylenically unsaturated bond.

The number average molecular weight of the polymer of the compound having a tertiary amino group and an ethylenically unsaturated bond, is not particularly limited and may be appropriately selected, but the number average molecular weight is preferably 1,000 to 500,000, and more preferably 5,000 to 200,000. If the number average molecular weight of the polymer of the compound having a tertiary amino group and an ethylenically unsaturated bond is less than 1,000, sufficient interlayer adhesiveness may not be exhibited, and if the number average molecular weight is more than 500,000, handleability of the polymer may be deteriorated.

Furthermore, the number average molecular weight of the polymer of the compound having an alkoxysilyl group and an ethylenically unsaturated bond is not particularly limited and may be appropriately selected, but the number average molecular weight is preferably 1,000 to 500,000, and more preferably 5,000 to 200,000. If the number average molecular weight of the polymer of the compound having an alkoxysilyl group and an ethylenically unsaturated bond is less than 1,000, sufficient interlayer adhesiveness may not be exhibited, and if the number average molecular weight is more than 500,000, handleability of the polymer may be deteriorated.

The number average molecular weight of the copolymer of the compound having a tertiary amino group and an ethylenically unsaturated bond and the compound having an alkoxysilyl group and an ethylenically unsaturated bond is not particularly limited and may be appropriately selected, but the number average molecular weight is preferably 1,000 to 500,000, and more preferably 5,000 to 200,000. If the number average molecular weight of the copolymer of the compound having a tertiary amino group and an ethylenically unsaturated bond and the compound having an alkoxysilyl group and an ethylenically unsaturated bond is less than 1,000, sufficient interlayer adhesiveness may not be exhibited, and if the number average molecular weight is more than 500,000, handleability of the polymer may be deteriorated.

There are no particular limitations on the polymer having an oxazoline group that is used in the present invention, and conventionally known products can be used. Among them, a polymer of a compound having an oxazoline group and an ethylenically unsaturated bond, in which the content of the oxazoline group in 1 g of the polymer is 0.1 to 10 moles, and more preferably 0.5 to 10 moles, is suitable. If the content of the oxazoline group in 1 g of the polymer is less than 0.1 moles, interlayer adhesiveness may be insufficient, and even if the content is more than 10 moles, any further special enhancement of interlayer adhesiveness cannot be expected. Here, the content of the oxazoline group contained in 1 g of the polymer having an oxazoline group, can be determined according to, for example, a method of adding an excess amount of carboxylic acid to the polymer to react with the oxazoline group, and then titrating the amount of remaining carboxylic acid with an alkali solution.

Specific examples of the compound having an oxazoline group and an ethylenically unsaturated bond include 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, 2-isopropenyl-5-methyl-2-oxazoline, and 2-isopropenyl-5-ethyl-2-oxazoline. Among them, 2-isopropenyl-2-oxazoline is preferred from the viewpoints of giving sufficient interlayer adhesiveness and being easily available. These compounds having an oxazoline group and an ethylenically unsaturated bond may be used singly, or two or more kinds may be used in combination.

The polymer having an oxazoline group may be a copolymer of a compound having an oxazoline group and an ethylenically unsaturated bond, with a compound having an ethylenically unsaturated bond. There are no particular limitations on the latter compound having an ethylenically unsaturated bond, but any compound capable of copolymerization with the compound having an oxazoline group and an ethylenically unsaturated bond, may be used without any particular limitation. Specific examples include α-olefins such as ethylene, propylene, n-butene and isobutylene; (meth)acrylic acid esters such as methyl (meth)acrylate, ethyl (meth)acrylate, n-propyl (meth)acrylate, i-propyl (meth)acrylate, n-butyl (meth)acrylate, i-butyl (meth)acrylate, t-butyl (meth)acrylate, 2-ethylhexyl (meth)acrylate, dodecyl (meth)acrylate, and octadecyl (meth)acrylate; (meth)acrylic acid salts such as sodium (meth)acrylate, potassium (meth)acrylate, and ammonium (meth)acrylate; (meth)acrylamide derivatives such as (meth)acrylamide, N-methyl(meth)acrylamide, N-ethyl(meth)acrylamide, N,N-dimethyl(meth)acrylamide, diacetone (meth)acrylamide, (meth)acrylamidopropanesulfonic acid and salts thereof, N-methylol(meth)acrylamide and derivatives thereof; vinyl ethers such as methyl vinyl ether, ethyl vinyl ether, n-propyl vinyl ether, i-propyl vinyl ether, n-butyl vinyl ether, i-butyl vinyl ether, t-butyl vinyl ether, dodecyl vinyl ether, and stearyl vinyl ether; nitriles such as (meth)acrylonitrile; vinyl halides such as vinyl chloride and vinyl fluoride; vinylidene halides such as vinylidene chloride and vinylidene fluoride; allyl compounds such as allyl acetate and allyl chloride; polyvalent unsaturated carboxylic acid salts such as sodium maleate; vinylsilyl compounds such as vinyltrimethoxysilane; and isopropenyl acetate. There are no particular limitations on the amount of introduction of these compounds having an ethylenically unsaturated bond into the copolymer, but the amount of introduction is, in terms of the mass ratio of (compound having an oxazoline group and an ethylenically unsaturated bond)/(compound having an ethylenically unsaturated bond), preferably 99/1 to 1/99, and more preferably 95/5 to 5/95. These compounds having an ethylenically unsaturated bond may be used singly, or two or more kinds may be used in combination.

The polymer having an oxazoline group can be polymerized by a conventionally known method, and the number average molecular weight is preferably 1,000 to 500,000, and more preferably 5,000 to 200,000. If the number average molecular weight of the polymer having an oxazoline group is less than 1,000, sufficient interlayer adhesiveness may not be exhibited, and if the number average molecular weight is more than 500,000, handleability of the polymer may be deteriorated.

In the case of adding the polymer having an oxazoline group into at least one layer of the polyvinyl acetal layer (layer A) and the resin layer (layer B) in the laminate of the present invention, there are no particular limitations on the amount of addition, but the total amount of the polymer having an oxazoline group with respect to the mass of the layer A and/ or layer B, to which the polymer is to be added, is preferably 0.001 % to 5% by mass, more preferably 0.005% to 3% by mass, and optimally 0.01% to 2% by mass. If the amount of the polymer having an oxazoline group is less than 0.001% by mass, sufficient interlayer adhesiveness may not be exhibited, and even if the amount is more than 5% by mass, any further special enhancement of interlayer adhesiveness cannot be expected.

Furthermore, in the case where the laminate of the present invention has an adhesive layer (layer C) containing the polymer having an oxazoline group, a method of forming the adhesive layer (layer C) using the polymer having an oxazoline group on the surface of a layer A and/or a layer B, and then laminating the layer A and the layer B; a method of separately producing a layer A, a layer B and a layer C, and then laminating the three layers; or the like may be used. There are no particular limitations on the content of the polymer having an oxazoline group in the layer C, but the content is suitably 80% by mass or more, more suitably 90% by mass or more, and optimally 95% by mass or more. If the content of the polymer having an oxazoline group is less than 80% by mass, sufficient interlayer adhesiveness may not be exhibited.

Next, the polyvinyl acetal layer (layer A) will be explained. A polyvinyl acetal is usually produced using a vinyl alcohol-based polymer as a raw material. The vinyl alcohol-based polymer can be obtained by a conventionally known technique, that is, a technique of polymerizing a vinyl ester-based monomer and saponifying the polymer thus obtained. Regarding the method for polymerizing a vinyl ester-based monomer, conventionally known methods such as a solution polymerization method, a bulk polymerization method, a suspension polymerization method, and an emulsion polymerization method, can be applied. As the polymerization initiator, an azo-based initiator, a peroxide-based initiator, a redox-based initiator and the like are appropriately selected in accordance with the polymerization method. The saponification reaction can be carried out by applying alcoholysis, hydrolysis and the like using conventionally known alkali catalysts or acid catalysts. Among these, a saponification reaction of using methanol as a solvent and using a caustic soda (NaOH) catalyst, is convenient and most preferred.

Examples of the vinyl ester-based monomer include vinyl formate, vinyl acetate, vinyl propionate, vinyl butyrate, vinyl isobutyrate, vinyl pivalate, vinyl versatate, vinyl caprate, vinyl caprylate, vinyl laurate, vinyl palmitate, vinyl stearate, vinyl oleate, and vinyl benzoate, and vinyl acetate is particularly preferred.

Furthermore, in the case of polymerizing the vinyl ester-based monomer, the vinyl ester-based monomer can also be copolymerized with other monomers as long as the gist of the present invention is maintained. Examples of the other monomers include the compounds exemplified as monomers that are capable of copolymerization with the adhesive polymer, the compounds exemplified as monomers that are capable of copolymerization with allylamines, and the monomers exemplified as compounds that are capable of copolymerization with the compound having an oxazoline group and an ethylenically unsaturated bond. These monomers are usually used at a proportion of less than 10% by mole with respect to the vinyl ester-based monomer.

The polyvinyl acetal that is used in the present invention can be obtained according to, for example, a method such as shown below. First, an aqueous solution of a vinyl alcohol-based polymer at a concentration of 3% to 30% by mass is regulated to a temperature range of 80°C to 100°C, and the aqueous solution is slowly cooled over 10 to 60 minutes. At the time point when the temperature has been lowered to -10°C to 30°C, an aldehyde and an acid catalyst are added to the solution, and while the temperature is maintained constant, an acetalization reaction is carried out for 30 to 300 minutes. Thereafter, the temperature of the reaction liquid is raised to a temperature of 40°C to 80°C over 30 to 200 minutes, and the temperature is maintained for 1 to 6 hours. Next, the reaction liquid is cooled to suitably room temperature, and is washed with water. A neutralizing agent such as an alkali is then added to the reaction liquid, and the mixture is washed with water and dried. Thus, the polyvinyl acetal used in the present invention is obtained.

There are no particular limitations on the acid catalyst used in the acetalization reaction, and any of an organic acid and an inorganic acid can be used. Examples thereof include acetic acid, paratoluenesulfonic acid, nitric acid, sulfuric acid, and hydrochloric acid. Among these, hydrochloric acid, sulfuric acid and nitric acid are preferably used, and particularly, hydrochloric acid is used with preference.

According to the present invention, it is preferable to use a polyvinyl acetal which has been acetalized with an aldehyde having 1 to 8 carbon atoms. Examples of the aldehyde having 1 to 8 carbon atoms include formaldehyde, acetaldehyde, propionaldehyde, n-butyl aldehyde, isobutyl aldehyde, n-hexyl aldehyde, 2-ethylbutyl aldehyde, n-octyl aldehyde, 2-ethylhexyl aldehyde, and benzaldehyde. These may be used singly, or two or more kinds may be used together. Among these, it is preferable to use an aldehyde having 2 to 6 carbon atoms, and particularly n-butyl aldehyde, in view of the mechanical strength of the polyvinyl acetal that is obtained. That is, polyvinyl butyral is particularly preferred as the polyvinyl acetal.

The average degree of acetalization of the polyvinyl acetal is preferably 40% to 85% by mole, suitably 50% to 82% by mole, and optimally 60% to 80% by mole. When a polyvinyl acetal having a degree of acetalization in this range is used, excellent interlayer adhesiveness, strength and transparency are obtained. Furthermore, in order to achieve the purpose of the present invention more suitably, the content of the vinyl ester unit of the polyvinyl acetal may be 0.01% to 30% by mole, suitably 0.05% to 15% by mole, and more suitably 0.1 % to 5% by mole. A polyvinyl acetal having a vinyl ester unit content in this range is preferred because of its superior weather resistance. Furthermore, the content of the vinyl alcohol unit may be 10% to 50% by mole, suitably 12% to 40% by mole, and optimally 15% to 35% by mole. Here, the values for the degree of acetalization, content of the vinyl ester unit, and content of the vinyl alcohol unit are values obtained by respectively dividing the material amount of the acetalized unit (material amount of the vinyl acetal unit), material amount of the vinyl ester unit, and material amount of the vinyl alcohol unit, by the sum of the material amounts of all monomer units of the polyvinyl acetal.

The viscosity average degree of polymerization of the vinyl alcohol-based polymer which serves as a raw material of the polyvinyl acetal that is used in the present invention, is appropriately selected in accordance with the use, but the viscosity average degree of polymerization is preferably 150 to 3,000, and more preferably 200 to 2,000. If the viscosity average degree of polymerization of the vinyl alcohol-based polymer is smaller than 150, the mechanical strength and the like that are inherent to the polyvinyl acetal may not be exhibited. If the viscosity average degree of polymerization is larger than 3,000, handleability (solvent solubility or melt kneadability) of the polyvinyl acetal may be deteriorated, which is not preferable.

The polyvinyl acetal layer (layer A) of the present invention may contain a plasticizer according to the purpose. There are no particular limitations on the plasticizer, but examples thereof include carboxylic acid ester-based plasticizers such as monovalent carboxylic acid ester-based ones and polyvalent carboxylic acid ester-based ones; phosphoric acid ester-based plasticizers; and organic phosphorous ester-based plasticizers.

A monovalent carboxylic acid ester-based plasticizer is a compound obtained by a condensation reaction between a monovalent carboxylic acid such as butanoic acid, isobutanoic acid, hexanoic acid, 2-ethylhexanoic acid, heptanoic acid, octylic acid, 2-ethylhexanoic acid or lauric acid, and a polyhydric alcohol such as ethylene glycol, diethylene glycol, triethylene glycol, tetraethylene glycol, polyethylene glycol, or glycerin. Specific examples of the monovalent carboxylic acid ester-based plasticizer include triethylene glycol di-2-ethylhexanoate, triethylene glycol diisobutanoate, triethylene glycol di-2-hexanoate, triethylene glycol di-2-ethylbutanoate, triethylene glycol dilaurate, ethylene glycol di-2-ethylhexanoate, diethylene glycol di-2-ethylhexanoate, tetraethylene glycol di-2-ethylhexanoate, tetraethylene glycol diheptanoate, PEG#400 di-2-ethylhexanoate, triethylene glycol mono-2-ethylhexanoate, and glycerin tri-2-ethylhexanoate. Here, the term PEG#400 indicates a polyethylene glycol having an average molecular weight of 350 to 450. A polyvalent carboxylic acid ester-based plasticizer is a compound obtained by a condensation reaction between a polyvalent carboxylic acid such as adipic acid, succinic acid, azelaic acid, sebacic acid, phthalic acid, isophthalic acid, terephthalic acid or trimellitic acid, and an alcohol having 1 to 12 carbon atoms such as methanol, ethanol, butanol, hexanol, 2-ethylbutanol, heptanol, octanol, 2-ethylhexanol, decanol, dodecanol, butoxyethanol, butoxyethoxyethanol, or benzyl alcohol. Specific examples of the compound include dihexyl adipate, di-2-ethylhexyl adipate, diheptyl adipate, dioctyl adipate, di(butoxyethyl) adipate, di(butoxyethoxyethyl) adipate, mono(2-ethylhexyl) adipate, dibutyl phthalate, dihexyl phthalate, di(2-ethylbutyl) phthalate, dioctyl phthalate, di(2-ethylhexyl) phthalate, benzyl butyl phthalate, and didodecyl phthalate.

A phosphoric acid-based plasticizer or a phosphorous acid-based plasticizer is a compound obtained by a condensation reaction between phosphoric acid or phosphorous acid, and an alcohol having 1 to 12 carbon atoms such as methanol, ethanol, butanol, hexanol, 2-ethylbutanol, heptanol, octanol, 2-ethylhexanol, decanol, dodecanol, butoxyethanol, butoxyethoxyethanol, or benzyl alcohol. Specific examples of the compound include trimethyl phosphate, triethyl phosphate, tripropyl phosphate, tributyl phosphate, tri(2-ethylhexyl) phosphate, tri(butoxyethyl) phosphate, and tri(2-ethylhexyl) phosphite.

Among these, in particular, triethylene glycol di-2-ethylhexanoate, triethylene glycol di-2-ethylbutyrate, tetraethylene glycol di-2-ethylhexanoate, tetraethylene glycol diheptanoate, dihexyl adipate, dioctyl adipate, di(2-ethylhexyl) adipate and the like are suitable from the viewpoints of the plasticizing effect on polyvinyl acetal, and the like.

According to the present invention, the plasticizers may be used singly, or two or more kinds may be used together. There are no particular limitations on the amount of use, but the amount of use of the plasticizer is preferably 0.1 to 80 parts by mass, suitably 0.5 to 70 parts by mass, and optionally 1 to 65 parts by mass, relative to 100 parts by mass of the polyvinyl acetal contained in the layer A. If the amount of use of the plasticizer is less than 0.1 parts by mass, sufficient plasticizing effects may not be exhibited, and even if the amount of use is larger than 80 parts by mass, any further special plasticizing effects cannot be expected.

Furthermore, the layer A may also contain an oxidation inhibitor, an ultraviolet absorber, and other conventionally known additives. Those additives will be explained in the following.

Examples of the oxidation inhibitor that is used in the layer A of the present invention include phenolic-based oxidation inhibitors, phosphorus-based oxidation inhibitors, and sulfur-based oxidation inhibitors. Among these, phenolic-based oxidation inhibitors are preferred, and alkyl-substituted phenolic-based oxidation inhibitors are particularly preferred.

Examples of the phenolic oxidation inhibitors include acrylate-based compounds such as 2-t-butyl-6-(3-t-butyl-2-hydroxy-5-methylbenzyl)-4-methylphenyl acrylate, and 2,4-di-t-amyl-6-(1-(3,5-di-t-amyl-2-hydroxyphenyl)ethyl)phenyl acrylate; alkyl-substituted phenol-based compounds such as 2,6-di-t-butyl-4-methylphenol, 2,6-di-t-butyl-4-ethylphenol, octadecyl-3-(3,5-di-t-butyl-4-hydroxyphenyl) propionate, 2,2'-methylenebis(4-methyl-6-t-butylphenol), 4,4'-butylidenebis(4-methyl-6-t-butylphenol), 4,4'-butylidenebis(6-t-butyl-m-cresol), 4,4'-thiobis(3-methyl-6-t-butylphenol), bis(3-cyclohexyl-2-hydroxy-5-methylphenyl)methane, 3,9-bis(2-(3-(3-t-butyl-4-hydroxy-5-methylphenyl)propionyloxy)-1,1-dim ethylethyl)-2,4,8,10-tetraoxaspiro[5,5]undecane, 1,1,3-tris(2-methyl-4-hydroxy-5-t-butylphenyl)butane, 1,3,5-trimethyl-2,4,6-tris(3,5-di-t-butyl-4-hydroxybenzyl)benzene, tetrakis(methylene-3-(3',5'-di-t-butyl-4'-hydroxyphenyl)propionate)meth ane, and triethylene glycol bis(3-(3-t-butyl-4-hydroxy-5-methylphenyl)propionate); and triazine group-containing phenolic compounds such as 6-(4-hydroxy-3,5-di-t-butylanilino)-2,4-bis-octylthio-1,3,5-triazine, 6-(4-hydroxy-3,5-dimethylanilino)-2,4-bis-octylthio-1,3,5-triazine, 6-(4-hydroxy-3-methyl-5-t-butylanilino)-2,4-bis-octylthio-1,3,5-triazine, and 2-octylthio-4,6-bis(3,5-di-t-butyl-4-oxyanilino)-1,3,5-triazine.

Examples of the phosphorus-based oxidation inhibitors include monophosphite-based compounds such as triphenyl phosphite, diphenylisodecyl phosphite, phenyldiisodecyl phosphite, tris(nonylphenyl) phosphite, tris(dinonylphenyl) phosphite, tris(2-t-butyl-4-methylphenyl) phosphite, tris(cyclohexylphenyl) phosphite, 2,2-methylenebis(4,6-di-t-butylphenyl)octyl phosphite, 9,10-dihydro-9-oxa-10-phosphaphenanthrene-10-oxide, 10-(3,5-di-t-butyl-4-hydroxybenzyl)-9,10-dihydro-9-oxa-10-phosphaphe nanthrene-10-oxide, and 10-decyloxy-9,10-dihydro-9-oxa-10-phosphaphenanthrene; and diphosphite-based compounds such as 4,4'-butylidenebis(3-methyl-6-t-butylphenylditridecyl phosphite), 4,4'-isopropylidene-bis(phenyldialkyl (C12-C15) phosphite), 4,4'-isopropylidene-bis(diphenylmonoalkyl (C12-C15) phosphite), 1,1,3-tris(2-methyl-4-ditridecylphosphite-5-t-butylphenyl)butane, and tetrakis(2,4-di-t-butylphenyl)-4,4'-biphenylene phosphite.

Examples of the sulfur-based oxidation inhibitors include dilauryl 3,3'-thiodipropionate, distearyl 3,3'-thiodipropionate, lauryl stearyl 3,3'-thiodipropionate, pentaerythritol-tetrakis-(β-laurylthiopropionate), and 3,9-bis(2-dodecylthioethyl)-2,4,8,10-tetraoxaspiro[5,5]undecane.

These oxidation inhibitors may be used singly, or two or more kinds may be used in combination. The amount of incorporation of the oxidation inhibitor may be in the range of 0.001 to 5 parts by mass, and preferably 0.01 to 1 parts by mass, relative to 100 parts by mass of the polyvinyl acetal resin. If the amount of the oxidation inhibitor is less than 0.001 parts by mass, sufficient effects may not be exhibited, and even if the amount is larger than 5 parts by mass, any further special effects cannot be expected.

Furthermore, examples of the ultraviolet absorber used in the layer A of the present invention include benzotriazole-based ultraviolet absorbers such as 2-(5-methyl-2-hydroxyphenyl)benzotriazole, 2-[2-hydroxy-3,5-bis(α,α'-dimethylbenzyl)phenyl]-2H-benzotriazole, 2-(3,5-di-t-butyl-2-hydroxyphenyl)benzotriazole, 2-(3-t-butyl-5-methyl-2-hydroxyphenyl)-5-chlorobenzotriazole, 2-(3,5-di-t-butyl-5-methyl-2-hydroxyphenyl)-5-chlorobenzotriazole, 2-(3,5-di-t-amyl-2-hydroxyphenyl)benzotriazole, and 2-(2'-hydroxy-5'-t-octylphenyl)benzotriazole; hindered amine-based ultraviolet absorbers such as 2,2,6,6-tetramethyl-4-piperidyl benzoate, bis(2,2,6,6-tetramethyl-4-piperidyl) sebacate, bis(1,2,2,6,6-pentamethyl-4-piperidyl)-2-(3,5-di-t-butyl-4-hydroxybenzyl )-2-n-butyl malonate, and 4-(3-(3,5-di-t-butyl-4-hydroxyphenyl)propionyloxy)-1-(2-(3-(3,5-di-t-buty 1-4-hydroxyphenyl)propionyloxy)ethyl)-2,2,6,6-tetramethylpiperidine; and benzoate-based ultraviolet absorbers such as 2,4-di-t-butylphenyl-3,5-di-t-butyl-4-hydroxybenzoate, and hexadecyl-3,5-di-t-butyl-4-hydroxybenzoate. The amount of addition of these ultraviolet absorbers is preferably in the range of 10 to 50,000 ppm, and more preferably 100 to 10,000 ppm, based on the mass of the layer A. If the amount of addition of the ultraviolet absorber is less than 100 ppm, sufficient effects may not be exhibited, and even if the amount of addition is larger than 50,000 ppm, any further special effects cannot be expected. These ultraviolet absorbers can be used in combination of two or more kinds.

Next, the resin that is used in the resin layer (layer B) will be explained. There are no particular limitations on the resin that is used in the layer B, but the resin is preferably a resin having any one of a carboxyl group, a phenolic hydroxyl group, an ester bond, an imide bond and a carbonate bond (-O-C(=O)-O-), from the viewpoint of interlayer adhesiveness. Particularly, the resin is preferably a polyester, a polyunsaturated carboxylic acid ester, an aromatic polyimide or an aromatic polycarbonate, from the viewpoint of interlayer adhesiveness. These resins may be contained singly in the layer B, or two or more kinds may be contained, but it is preferable that one kind of the resin be contained. The total amount of these resins contained in the layer B is preferably 80% by mass or more, more suitably 95% by mass or more, and even more suitably 98% by mass or more, based on the total mass of the layer B.

There are no particular limitations on the polyester, and those conventionally known products can be used. Examples thereof include polyethylene terephthalate, polypropylene terephthalate, polybutylene terephthalate, and polyethylene naphthalate.

There are no particular limitations on the polyunsaturated carboxylic acid esters, and those conventionally known products can be used. Examples thereof include polymethyl (meth)acrylate, and polyethyl (meth)acrylate.

There are no particular limitations on the aromatic polyimide, and those conventionally known products can be used. Examples thereof include a product obtained by an alternate polycondensation reaction of pyromellitic acid dianhydride with 4,4'-diaminodiphenyl ether.

There are no particular limitations on the aromatic polycarbonate, and those conventionally known products can be used. Examples thereof include a product obtained by an alternate polymerization reaction of bisphenol A or bisphenol F with phosgene or diphenyl carbonate.

The reason why a laminate having strong interlayer adhesiveness is obtained by using the polyester, polyunsaturated carboxylic acid ester, aromatic polyimide and aromatic polycarbonate described above in the laminate of the present invention, is not sufficiently clearly known. However, it is speculated that the carboxyl group or phenolic hydroxyl group contained in the polyester, polyunsaturated carboxylic acid ester, aromatic polyimide and aromatic polycarbonate (based on the terminal groups in the case of the polyester and aromatic polycarbonate, and based on hydrolysis of some bonds in the case of the polyunsaturated carboxylic acid and aromatic polyimide) is derived from having a strong interaction or forming chemical bonding with the polymer having an amino group which is used as an essential component of the laminate of the present invention.

Furthermore, as the resin layer (layer B), use can be made of a resin layer of the polyester, polyunsaturated carboxylic acid ester, aromatic polyimide, aromatic polycarbonate or the like, as well as a resin layer of polyethylene, polypropylene, polyvinyl acetate, an ethylene-vinyl acetate copolymer, polystyrene, polyvinyl alcohol, polyvinyl chloride, polyurethane, polyamideimide or the like, which has been subjected to a discharge treatment (corona treatment, plasma treatment, or the like) at the surface. It is speculated that a polar functional group such as a carboxyl group is produced at the surface of the resin layer which has been subjected to a discharge treatment, and this polar functional group has a strong interaction with or forms chemical bonding with the polymer having an amino group which is used as an essential component in the laminate of the present invention, so that strong interlayer adhesiveness to the laminate of the present invention is exhibited.

Furthermore, the layer B of the present invention may contain the oxidation inhibitor, ultraviolet absorber, and other conventionally known additives described above. There are no particular limitations on the amount of addition of those additives, but the amount of addition of each of the additives based on the mass of the layer B is suitably 0.001 % to 5% by mass.

In regard to the layer A that is used in the present invention, a layer produced by a conventionally known method can be used. For example, the layer A can be produced by kneading a polyvinyl acetal together with the adhesive compound (in the case where the layer A contains the adhesive compound), a polymer having a primary amino group and/or a secondary amino group (in the case where the layer A contains a polymer having a primary amino group and/or a secondary amino group), or the polymer having an oxazoline group (in the case where the layer A contains the polymer having an oxazoline group), and optionally with a plasticizer and other additives using a mixing roll or the like, and molding the kneading product thus obtained into a sheet form by a known method such as a hot press molding machine, a calendar roll or an extruder. Furthermore, the layer A can also be produced by dissolving a polyvinyl acetal, together with the adhesive compound (in the case where the layer A contains the adhesive compound) and optionally with a plasticizer and other additives in a good solvent of polyvinyl acetals, casting the solution, and drying the solution. Examples of the good solvent of polyvinyl acetals include, but are not limited to, lower alcohols such as ethanol, propanol and butanol; acetone, methyl ethyl ketone, tetrahydrofuran, 1,4-dioxane, dimethyl sulfoxide, and chloroform.

Furthermore, in regard to the layer B that is used in the present invention, a layer produced by a conventionally known method can be used. For example, the layer B can be produced by kneading the resin contained in the layer B, a polymer having a primary amino group and/or a secondary amino group (in the case where the layer B contains a polymer having a primary amino group and/or a secondary amino group) or the polymer having an oxazoline group (in the case where the layer B contains the polymer having an oxazoline group), and optionally various additives using a mixing roll or the like, and molding the kneading product thus obtained into a sheet form by a known method such as a hot press molding machine, a calendar roll or an extruder. Furthermore, the layer B can also be produced by dissolving the resin contained in the layer B and optionally various additives in a solvent, casting the solution, and drying the solution.

The constitution of lamination in the laminate of the present invention can be determined according to the purpose, and suitable examples include layer A/layer C/layer B, layer A/layer C/layer B/layer C/layer A, and layer A/layer C/layer B/layer C/layer A/layer C/layer B/layer C/layer A. The laminate may definitely further include one or more of a layer other than the layer A, layer B or layer C (referred to as layer D), and the laminate may also have a constitution of, for example, layer A/layer C/layer B/layer D/layer B/layer C/layer A or layer A/layer C/layer B/layer D. Further examples include laminates produced by adding the adhesive compound, a polymer having a primary amino group and/or a secondary amino group, or the polymer having an oxazoline group, to the layer A and/or layer B of a laminate composed of layer A/layer B, layer A/layer B/layer A, layer A/layer B/layer A/layer B/layer A, or the like. In this case as well, the laminate may also include one or more of a layer other than the layer A or layer B (referred to as layer D), and the laminate may have a constitution of, for example, layer A/layer B/layer D/layer B/layer A, or layer A/layer B/layer D. Here, any known resin layer can be used as the layer D, and examples of the resin include various thermoplastic elastomers and various rubbers based on polystyrene, vinyl chloride, polyolefin and polyurethane. In these layer A, layer B, layer C and layer D, conventionally known additives such as an oxidation inhibitor, a stabilizer, and an ultraviolet absorber may be incorporated as necessary. Furthermore, when the laminate of the present invention includes two or more kinds of layer A, two or more kinds of layer B, two or more kinds of layer C, or two or more kinds of layer D, the type of those layers may be identical with or different from each other.

The thickness of each layer in the laminate of the present invention can be determined based on the use. The thickness per layer of each layer is such that the thickness of the layer A is suitably 20 to 5,000 µm, more suitably 20 to 2,000 µm, and even more suitably 20 to 1,600 µm; the thickness of the layer B is suitably 5 to 10,000 µm, more suitably 5 to 5,000 µm, and even more suitably 5 to 3,000 µm; and in the case where the laminate includes the layer C, the thickness of the layer C is suitably 0.001 to 100 µm, more suitably 0.005 to 70 µm, and even more suitably 0.01 to 50 µm. When two or more layers of the same type are included in the laminate of the present invention, the thicknesses of those layers may be identical or different.

The laminate of the present invention exhibits excellent effects when used as an intermediate film for laminated glass. In regard to the constitution of lamination in the case of using the laminate of the present invention as an intermediate film for laminated glass, it is particularly preferable that the laminate have the layer A as the outermost layer of the laminate in the constitution described above, when the mechanical strength of the intermediate filmor adhesiveness to glass is considered.

There are no particular limitations on the thickness of each layer in the case of using the laminate of the present invention as an intermediate film, and the thickness can be appropriately selected according to the purpose. However, the thickness is suitably 20 to 2,000 µm, more suitably 20 to 1,800 µm, and even more suitably 20 to 1,500 µm for the layer A; the thickness is suitably 5 to 10,000 µm, more suitably 5 to 5,000 µm, and even more suitably 5 to 3,000 µm for the layer B; and in the case where the laminate includes the layer C, the thickness is suitably 0.001 to 50 µm, more suitably 0.005 to 30 µm, and even more suitably 0.01 to 10 µm for the layer C. There are no particular limitations on the thickness of the entire intermediate film, and the thickness can be appropriately selected according to the purpose. However, the thickness is suitably 100 to 15,000 µm, more suitably 200 to 10,000 µm, and optimally 300 to 5,000 µm. Furthermore, when the laminate of the present invention is used as an intermediate film, it is preferable that the layer A include a plasticizer, and the amount of use of the plasticizer is preferably 15 to 80 parts by mass, suitably 20 to 70 parts by mass, and optimally 25 to 60 parts by mass, relative to 100 parts by mass of the polyvinyl acetal resin.

In the case of using the laminate of the present invention as an intermediate film for laminated glass, there are no particular limitations on the layer B, but a polyester, a polyunsaturated carboxylic acid ester, an aromatic polyimide, an aromatic polycarbonate and the like are particularly suitable for increasing the strength of the intermediate film.

There are no particular limitations on the glass that is used in laminated glass, and examples of the glass include inorganic glass such as float plate glass, polished plate glass, template glass, wire plate glass, or heat absorbing plate glass; and conventionally known organic glass. The glass may be any of colorless glass, colored glass, transparent glass and opaque glass. These glass types may be used singly, or two or more kinds may be used in combination. Furthermore, the thickness of glass is not particularly limited, but is preferably 50 mm or less.

When the laminate of the present invention is used as an intermediate film for laminated glass, it is preferable that an adhesiveness control agent be added to the outermost layer of the intermediate film for the purpose of regulating the adhesiveness to glass. As the adhesiveness control agent, for example, those compounds disclosed in International PCT Patent Application No. WO 03/033583 can be used, and addition of alkali metal salts and/or alkaline earth metal salts of organic acids is preferably used. Particularly, potassium acetate and/or magnesium acetate is preferred. The amount of addition of the adhesiveness control agent is preferably 1 to 10,000 ppm, more preferably 5 to 1,000 ppm, and even more preferably 10 to 300 ppm, based on the mass of the outermost layer. The optimal amount of addition of the adhesiveness control agent varies with the additives used, and also varies depending on the place where the resulting laminated glass is used. However, it is preferable that the adhesive power of the film thus obtained to glass is generally adjusted to 3 to 10 in the Pummel test; described in International PCT Patent Application No. WO 03/033583, and the like). Particularly, in the case where high permeability resistance is required, the adhesive power is preferably adjusted to 3 to 6, and in the case where high glass shatter proof properties are required, the adhesive power is preferably adjusted to 7 to 10. When high glass shatter proof properties are required, it is also useful not to add an adhesive improving agent.

The laminated glass of the present invention can be produced by conventionally known methods. For example, the intermediate film for laminated glass of the present invention is inserted between two sheets of float plate glass, and this insertion product is placed in a vacuum bag and maintained in an oven at about 100°C for 30 minutes in a vacuum to thereby preliminarily bonding the insertion product. The insertion product removed from the vacuum bag is treated with a pressure of 1.5 to 20 kg/cm² in an autoclave at 120°C to 150°C, and thereby transparent laminated glass can be obtained.

Furthermore, the laminate of the present invention is excellent in interlayer adhesiveness, strength and transparency, and the laminate suffers less deterioration in weather resistance even after a long-term use. Therefore, the laminate exhibits excellent effects even in a solar cell module. In recent years, photovoltaic power generation is attracting attention as an environment-friendly energy. The basic configuration of a solar cell module is a laminate structure which includes a power generating element (cell) formed of a silicon compound such as crystalline silicon or amorphous silicon, CIS, CIGS, CdS/CdTe or GaAs; a flexible organic polymer sealant which protects the power generating element from external impact or the like; and glass plates, laminate resin sheets or single layer resin sheets which have the two components interposed therebetween for the purpose of protecting the sealant or blocking moisture that causes cell deterioration. For instance, FIG. 1 shows a schematic diagram of a solar cell module in which crystalline silicon is sealed. Application of plasticized polyvinyl acetal as a sealant 2 has been investigated, due to the material's high weather resistance or flexibility. The laminate resin sheet 1 that is used at this time, is generally a laminate resin sheet 1 which particularly uses a resin layer having low moisture permeability such as polyethylene terephthalate or polyethylene 2,6-naphthalate, and a high weather-resistant resin such as a fluorine-containing resin, that is, (resin layer with low moisture permeability/weather-resistant resin layer) for the innermost layers (layers in contact with the sealant 2). Furthermore, a high weather-resistant polyester sheet or the like is used as the single layer resin sheet 1. For the purpose of increasing the resistance to moisture permeability, products obtained by laminating an inorganic material layer by deposition on these sheets, or products obtained by dispersing an inorganic material in these sheets, are also used.

Thus, the solar cell module described in the present invention having excellent interlayer adhesiveness can be obtained by using a polyvinyl acetal layer (layer A) as a sealant layer in a laminate structure composed of (glass/sealant layer/laminate resin sheet) or a laminate structure composed of (glass/sealant layer/single layer resin sheet) as the laminate structure of the solar cell module, a laminate structure in which glass 1 in these laminate structures has been replaced by a laminate resin sheet 1 or single layer resin sheet 1, and a laminate including these laminate structures, which serve as the laminate structure of the solar cell module; also using a layer (layer B) selected from a polyester, a polyunsaturated carboxylic acid ester, an aromatic polyimide, an aromatic polycarbonate, and a resin layer which has been subjected to a discharge treatment, in the layer on the sealant 2 side of the laminate resin sheet 1 or in the single layer resin sheet 1; and adding the adhesive compound, a polymer having a primary amino group and/or a secondary amino group, or the polymer having an oxazoline group to the sealant 2, or forming an adhesive layer (layer C) containing the adhesive compound, a polymer having a primary amino group and/or a secondary amino group, or the polymer having an oxazoline group, between the sealant layer and the layer on the sealant 2 side of the laminate resin sheet 1 or between the sealant layer and the single layer resin sheet 1.

The solar cell module described in the present invention may have a conventionally known configuration, except that the laminate of the present invention is included, and the solar cell module may include, for example, an electrode connecting power generating elements, and transparent electrodes.

There are no particular limitations on the method for producing the solar cell module according to the present invention, but there may be mentioned, for example, a method of superimposing glass 1 (a power generating element layer such as amorphous silicon or CIGS may be formed on the surface of the sealant 2 side) / sealant layer (may contain the adhesive compound, a polymer having a primary amino group and/or a secondary amino group, or the polymer having an oxazoline group, and may further including a power generating element such as crystalline silicon in the inside) / adhesive layer/laminate resin sheet, and sealing the power generating element according to a conventionally known method, for example, a method of hot pressing the laminate with a vacuum laminator at a temperature of 100°C to 180°C, suitably 115°C to 175°C, and optimally 120°C to 170°C, for a degassing time of 0.1 to 10 minutes, at a press pressure of 0.1 to 20 kg/cm², for a pressing time of 1 to 120 minutes. For the configuration described above, it is preferable to use a configuration in which an adhesive layer has been formed in advance on the surface of the laminate resin sheet 1.

### EXAMPLES

The present invention will be explained below in more detail by way of Examples, but the present invention is not intended to be limited by these Examples. In addition, the terms "%" and "part" in the following Examples mean "% by mass" and "part by mass", unless particularly stated otherwise.

### Synthesis Example 1

### (Preparation of polyvinyl butyral)

In a 5-liter (L) glass container equipped with a circulating cooler, a thermometer and an anchor type agitating blade, 4050 g of ion-exchanged water and 330 g of a polyvinyl alcohol (PVA-1) (degree of polymerization 1700, degree of saponification 99% by mole) were introduced (PVA concentration 7.5%), and the temperature of the content was raised to 95°C to completely dissolve the content. Subsequently, the content was slowly cooled to 5°C over about 30 minutes under stirring at 120 rpm, and then 192 g of butyl aldehyde and 270 mL of 20% hydrochloric acid were added thereto. Thus, a butyralization reaction was carried out for 150 minutes. Thereafter, the temperature of the reaction liquid was raised to 50°C over 60 minutes and was maintained at 50°C for 120 minutes. The reaction liquid was then cooled to room temperature. A resin precipitated therefrom was washed with ion-exchanged water, and then an excess amount of aqueous solution of sodium hydroxide was added thereto. The resin was washed again and dried, and thus a polyvinyl butyral (PVB-1) was obtained. The degree of butyralization of the PVB-1 thus obtained was 69% by mole, the content of the vinyl acetate group was 1% by mole, and the content of the vinyl alcohol group was 30% by mole. The degree of butyralization of PVB-1 and the content of the remaining vinyl acetate group were measured according to JIS K6728.

### Example 1

### (Production of polyvinyl acetal film)

40 g of PVB-1 and 18 g of a plasticizer (triethylene glycol di-2-ethylhexanoate) were kneaded with a Labo Plastomill (160°C, 10 minutes). 4.2 g of the kneading product thus obtained was hot pressed in a mold form having a size of 10 cm × 10 cm × 0.4 mm, and thus a PVB film-1 was obtained.

### (Production of surface treated PET film)

100 g of toluene, 0.5 g of 2-dimethylaminoethyl methacrylate, 0.5 g of methyltrimethoxysilane, and 0.001 g of benzoyl peroxide were mixed and dissolved. The solution thus obtained was applied on one surface of a polyethylene terephthalate film (Teijin Tetoron Film O3: thickness 50 µm) to a thickness of 30 µm using an applicator (thickness after drying 0.3 µm). Toluene was dried, and then this polyester film was heat treated at 100°C for 30 minutes to polymerize 2-dimethylaminoethyl methacrylate. Thus, a surface treated PET film-1 was obtained.

### (Production of laminate)

One sheet of the PVB film-1 and one sheet of the surface treated PET film-1 were superimposed such that the surface treated side of the surface treated PET film-1 faced the PVB film-1 side, and the films were adhered by hot pressing at 135°C and 12 kg/cm² for 30 minutes. Thus, a laminate-1 was obtained (total thickness 450 µm).

### (Evaluation of laminate adhesiveness)

The laminate-1 was cut into a strip form having a size of 1 cm × 8 cm, and was humidified overnight at 23°C and 50% RH. The strip was peeled for a distance of about 2 cm from the end along the longer edge direction (the peel distance at this time is designated as 0 cm), and a T-peel test was performed 5 times at a rate of 100 mm/min by using an autograph (Autograph AG-IS manufactured by Shimadzu Corp.). An average value of the peel stress was determined. The evaluation results are presented in Table 1.

### (Evaluation of laminate stability)

The laminate-1 was treated for 2 weeks under the conditions of 120°C and 50% RH, and ΔYI value, the amount of change in YI (yellow index) after treatment with respect to the YI before treatment, was measured (Color meter SM-T-H1, manufactured by Suga Test Instruments Co., Ltd.). The evaluation results are presented in Table 1.

### Example 2

A laminate was produced in the same manner as in Example 1, except that butyltrimethoxysilane was used instead of methyltrimethoxysilane, and the adhesiveness and stability of the laminate were evaluated. The evaluation results are presented in Table 1.

### Example 3

A laminate was produced in the same manner as in Example 1, except that 4-vinylpyridine was used instead of 2-dimethylaminoethyl methacrylate, and the adhesiveness and stability of the laminate were evaluated. The evaluation results are presented in Table 1.

### Example 4

### (Production of surface treated PET film)

100 g of toluene, 0.5 g of 2-dimethylaminoethyl methacrylate, 0.5 g of 3-methacryloyloxypropyltrimethoxysilane, and 0.001 g of benzoyl peroxide were mixed and dissolved. The solution thus obtained was applied on one surface of a polyethylene terephthalate film (Teijin Tetoron Film O3: thickness 50 µm) to a thickness of 30 µm by using an applicator (thickness after drying 0.3 µm). Toluene was dried, and then this polyester film was heat treated at 100°C for 30 minutes to copolymerize 2-dimethylaminoethyl methacrylate and 3-methacryloyloxypropyltrimethoxysilane. Thus, a surface treated PET film-4 was obtained.

### (Production of laminate)

One sheet of the PVB film-1 and one sheet of the surface treated PET film-4 were superimposed such that the surface treated side of the surface treated PET film-4 faced the PVB film-1 side, and the films were adhered by hot pressing at 135°C and 12 kg/cm² for 30 minutes. Thus, a laminate was obtained (total thickness 450 µm). An evaluation was carried out on the laminate thus obtained, by the same method as that used in Example 1. The evaluation results are presented in Table 1.

### Example 5

A laminate was produced in the same manner as in Example 4, except that 2-diethylaminoethyl methacrylate was used instead of 2-dimethylaminoethyl methacrylate, and the adhesiveness and stability of the laminate were evaluated. The evaluation results are presented in Table 1.

### Example 6

### (Synthesis of polymer having tertiary amino group)

100 mL of deionized water, 10 g of 2-dimethylaminoethyl methacrylate, and 10 mL of a 0.1 wt% ethanol solution of azobisisobutyronitrile were added to a 500-mL separable flask in a constant-temperature water tank maintained at 60°C, and the mixture was stirred for 5 hours while maintained at 60°C, to carry out polymerization. The solution thus obtained was dried for 12 hours at 40°C and 10 mmHg to distill off the solvent, and 9.9 g of a tertiary amino group-containing polymer was obtained. A laminate was produced in the same manner as in Example 4, except that the tertiary amino group-containing polymer thus obtained was used instead of 0.5 g of 2-dimethylaminoethyl methacrylate, and the adhesiveness and stability of the laminate were evaluated. The evaluation results are presented in Table 1.

### Example 7

A surface treated polymethyl methacrylate film was produced using a polymethyl methacrylate (Mitsubishi Rayon Co., Ltd., Acrylite L, thickness 2 mm) instead of the polyester film used in Example 4. Thereafter, a laminate was produced in the same manner as in Example 1, and an evaluation was carried out. The evaluation results are presented in Table 1.

### Example 8

A surface treated aromatic polyimide film was produced using an aromatic polyimide film (Ube Industries, Ltd., Upilex S25, thickness 25 µm) instead of the polyester film used in Example 4. Thereafter, a laminate was produced in the same manner as in Example 1, and an evaluation was carried out. The evaluation results are presented in Table 1.

### Example 9

A surface treated aromatic polycarbonate film was produced using an aromatic polycarbonate film (Sumitomo Bakelite Co., Ltd., Polyca Ace ECK100, thickness 2 mm) instead of the polyester film used in Example 4. Thereafter, a laminate was produced in the same manner as in Example 1, and an evaluation was carried out. The evaluation results are presented in Table 1.

### Example 10

A polypropylene film (thickness 0.8 mm) was produced by hot pressing polypropylene (Japan Polypropylene Corp., Novatec PPMA3) at 200°C and 12 kg/cm² for 5 minutes. The polypropylene film was treated (300 W, 1 second) by using a corona treatment machine (AGF-B10S, manufactured by Kasuga Electric Works, Ltd.), and thus a corona-treated polypropylene film was obtained. The corona-treated polypropylene film was used instead of the polyester film used in Example 4. Thereafter, a laminate was produced in the same manner as in Example 1, and an evaluation was carried out. The evaluation results are presented in Table 1.

### Example 11

### (Production of surface treated PET film)

100 g of toluene, 0.5 g of 2-dimethylaminoethyl methacrylate, 0.5 g of 3-methacryloyloxypropyltrimethoxysilane, and 0.001 g of benzoyl peroxide were mixed and dissolved. The solution thus obtained was applied on one surface of a polyethylene terephthalate film (Teijin Tetoron Film O3: thickness 50 µm) to a thickness of 30 µm by using an applicator (thickness after drying 0.3 µm). Toluene was dried, and then the other surface of the polyethylene terephthalate film was subjected to the same treatment. Toluene was dried, and this polyester film was heat treated at 100°C for 30 minutes to copolymerize 2-dimethylaminoethyl methacrylate and 3-methacryloyloxypropyltrimethoxysilane. Thus, a surface treated PET film-11 was obtained.

### (Production of laminate)

The PVB film-1, the surface treated PET film-11, and the PVB film-1 were superimposed in this order, and the films were adhered by hot pressing at 135°C and 12 kg/cm² for 30 minutes. Thus, an intermediate film for laminated glass was obtained (total thickness 850 µm).

### (Production of laminated glass)

A transparent silicon glass, the intermediate film for laminated glass, and a transparent silicon glass were superimposed in this order, and this assembly was placed in a rubber bag. The pressure inside the rubber bag was reduced to 0.01 kg/cm², and the assembly was treated at 100°C to pre-adhere the assembly. The pre-adhesion product thus obtained was pressed for 20 minutes under the conditions of 140°C and 12 kg/cm² in an autoclave, and thus a laminated glass was obtained.

### Example 12

A glass substrate having a thickness of 3 mm, the PVB film-1, a silicon power generating element, the PVB film-1, and the surface treated PET film-1 were superimposed, and the assembly was heated using a vacuum laminator under the conditions of a hot plate temperature of 150°C, a degassing time of 1.5 minutes, a press pressure of 1 kg/cm², and a pressing time of 5 minutes, to seal the silicon power generating element. Thus, a solar cell module was obtained.

### Example 13

10 g of PVB-1 was dissolved in 190 g of ethanol to prepare a 5% PVB-ethanol solution. Subsequently, a mold form having the surface treated PET film-4 produced in Example 4 at the bottom side, and a size of 10 cm in length, 10 cm in width and 2 cm in height was produced. 20 g of the 5% PVB-ethanol solution was poured into the mold form, the solution was dried at room temperature, and thus a laminate was produced. The laminate thus obtained was evaluated in the same manner as in Example 1. The evaluation results are presented in Table 1.

### Example 14

### (Production of polyvinyl acetal film containing polymer having tertiary amino group)

40 g of PVB-1, 18 g of a plasticizer (triethylene glycol di-2-ethylhexanoate), 0.4 g of the tertiary amino group-containing polymer synthesized in Example 6, and 0.4 g of butyltrimethoxysilane were kneaded with a Labo Plastomill (160°C, 10 minutes). 4.2 g of the kneading product thus obtained was hot pressed in a mold form having a size of 10 cm × 10 cm × 0.4 mm, and thus a PVB film was obtained.

### (Production of laminate)

One sheet of the PVB film and one sheet of a PET film (Teijin Tetoron Film O3: thickness 50 µm) were superimposed, and the films were adhered by hot pressing at 135°C and 12 kg/cm² for 30 minutes. Thus, a laminate was obtained (total thickness 450 µm). The laminate thus obtained was evaluated in the same manner as in Example 1. The evaluation results are presented in Table 1.

### Example 15

10 g of PVB-1, 0.1 g of the tertiary amino group-containing polymer synthesized in Example 6, and 0.1 g of butyltrimethoxysilane were dissolved in 190 g of ethanol, and thus a 5% PVB-ethanol solution was obtained. Subsequently, a mold form having a size of 10 cm in length, 10 cm in width and 2 cm in height was produced using a PET film (Teijin Tetoron Film O3: thickness 50 µm) as the bottom side of the mold form. 20 g of the 5% PVB-ethanol solution was poured into the mold form, the solution was dried at room temperature, and thus a laminate was produced. The laminate thus obtained was evaluated in the same manner as in Example 1. The evaluation results are presented in Table 1.

[Table 1]

**[Table 1]**

| | Layer A | Layer B | Adhesive compound | | Peel stress [N/cm] | ΔYI |
|---|---|---|---|---|---|---|
| Example 1 | PVB-1/Plasticizer | Polyester | *1 | Layer C | 11.4 | 6.5 |
| Example 2 | PVB-1/Plasticizer | Polyester | *2 | Layer C | 10.8 | 6.7 |
| Example 3 | PVB-1/Plasticizer | Polyester | *3 | Layer C | 9.8 | 8.2 |
| Example 4 | PVB-1/Plasticizer | Polyester | *4 | Layer C | 12.4 | 6.1 |
| Example 5 | PVB-1/Plasticizer | Polyester | *5 | Layer C | 12.0 | 5.1 |
| Example 6 | PVB-1/Plasticizer | Polyester | *6 | Layer C | 10.8 | 4.9 |
| Example 7 | PVB-1/Plasticizer | Polymethyl methacrylate | *4 | Layer C | 6.6 | 8.0 |
| Example 8 | PVB-1/Plasticizer | Aromatic polyimide | *4 | Layer C | 15.2 | - |
| Example 9 | PVB-1/Plasticizer | Aromatic polycarbonate | *4 | Layer C | 9.3 | 7.9 |
| Example 10 | PVB-1/Plasticizer | Corona-treated polypropylene | *4 | Layer C | 5.6 | 11.5 |
| Example 13 | PVB-1 | Polyester | *4 | Layer C | 13.4 | 4.1 |
| Example 14 | PVB-1/Plasticizer | Polyester | *2 | Added to Layer A | 13.2 | 5.9 |
| Example 15 | PVB-1 | Polyester | *2 | Added to Layer A | 17.2 | 5.0 |
| Example 29 | PVB-1/Plasticizer | Polyester | *11 | Added to Layer A | 12.9 | 6.0 |
| Example 30 | PVB-1/Plasticizer | Polyester | *12 | Added to Layer A | 13.0 | 5.8 |

| | | | | | | |
|---|---|---|---|---|---|---|
| *1: Polymer of 2-dimethylaminoethyl methacrylate + methyltrimethoxysilane *2: Polymer of 2-dimethylaminoethyl methacrylate + buthyltrimethoxysilane *3: Polymer of 4-vinylpyridine and methyltrimethoxysilane *4: Copolymer of 2-dimethylaminoethyl methacrylate and 3-methacryloxypropyltrimethoxysilane *5: Copolymer of 2-diethylaminoethyl methacrylate and 3-methacryloxypropyltrimethoxysilane *6: Polymer of 2-dimethylaminoethyl methacrylate and polymer of 3-methacryloxypropyltrimethoxysilane *11: Polymer of 2-dimethylaminoethyl methacrylate and polymer of 3-methacryloxypropyltrimethoxysilane *12: Copolymer of 2-dimethylaminoethyl methacrylate and 3-methacryloxypropyltrimethoxysilane | | | | | | |

### Example 16

A glass substrate having a thickness of 3 mm, the PVB film-1, a silicon power generating element, the PVB film-1, and the surface treated PET film-1 were superimposed, and the assembly was heated by using a vacuum laminator under the conditions of a hot plate temperature of 150°C, a degassing time of 1.5 minutes, a press pressure of 1 kg/cm², and a pressing time of 5 minutes, to seal the silicon power element. Thus, a solar cell module was obtained.

### Example 17

### (Production of polyvinyl acetal film)

40 g of PVB-1 and 18 g of a plasticizer (triethylene glycol di-2-ethylhexanoate) were kneaded with a Labo Plastomill (160°C, 10 minutes). 4.2 g of the kneading product thus obtained was hot pressed in a mold form having a size of 10 cm x 10 cm x 0.4 mm, and thus a PVB film-1 was obtained.

### (Production of surface treated PET film)

2.5 g of an oxazoline group-containing polymer solution (Nippon Shokubai Co., Ltd., EPOCROS WS-500, solids content 39 wt%, contains a polymer of a compound having an oxazoline group and an ethylenically unsaturated bond; amount of oxazoline group in 1 g of the polymer is 4.5 mmol) was mixed and dissolved in 98 g of deionized water. The solution thus obtained was applied on one surface of a polyethylene terephthalate film (Teijin Tetoron Film O3: thickness 50 µm) to a thickness of 30 µm by using an applicator (thickness after drying 0.3 µm). The solution was dried, and then this polyester film was heat treated at 100°C for 30 minutes. Thus, a surface treated PET film-30 was obtained.

### (Production of laminate)

One sheet of the PVB film-1 and one sheet of the surface treated PET film-30 were superimposed such that the surface treated side of the surface treated PET film-30 faced the PVB film side, and the assembly was adhered by hot pressing at 135°C and 12 kg/cm² for 30 minutes. Thus, a laminate-30 was obtained (total thickness 450 µm).

### (Evaluation of laminate adhesiveness)

The laminate-30 was cut into a strip form having a size of 1 cm x 8 cm, and was humidified overnight at 23°C and 50% RH. The strip was peeled for a distance of about 2 cm from the end along the longer edge direction (the peel distance at this time is designated as 0 cm), and a 180°-peel test was performed 5 times at a rate of 100 mm/min by using an autograph (Autograph AG-IS manufactured by Shimadzu Corp.). An average value of the peel stress was determined. The evaluation results are presented in Table 2.

### (Evaluation of laminate stability)

The laminate-30 was treated for 2 weeks under the conditions of 120°C and 50% RH, and ΔYI value, the amount of change in YI (yellow index) after treatment with respect to the YI before treatment, was measured (Color meter SM-T-H1, manufactured by Suga Test Instruments Co., Ltd.). The evaluation results are presented in Table 2.

### Example 18

### (Production of surface treated PET film)

98 g of deionized water, and 4 g of an oxazoline group-containing polymer solution (Nippon Shokubai Co., Ltd., EPOCROS WS-700, solids content 25 wt%, contains a polymer of a compound having an oxazoline group and an ethylenically unsaturated bond; amount of oxazoline group in 1 g of the polymer is 4.5 mmol) were mixed and dissolved. The solution thus obtained was applied on one surface of a polyethylene terephthalate film (Teijin Tetoron Film O3: thickness 50 µm) to a thickness of 30 µm by using an applicator (thickness after drying 0.3 µm). The solution was dried, and then this polyester film was heat treated at 100°C for 30 minutes. Thus, a surface treated PET film-31 was obtained.

### (Production of laminate)

One sheet of the PVB film-1 and one sheet of the surface treated PET film-31 were superimposed such that the surface treated side of the surface treated PET film-31 faced the PVB film side, and the assembly was adhered by hot pressing at 135°C and 12 kg/cm² for 30 minutes. Thus, a laminate-30 was obtained (total thickness 450 µm).

The laminate was subjected to an evaluation by the same method as that used in Example 17. The evaluation results are presented in Table 2.

### Example 19

A surface treated polymethyl methacrylate film was produced using a polymethyl methacrylate film (Mitsubishi Rayon Co., Ltd., Acrylite L, thickness 2 mm) instead of the polyester film used in Example 17. Thereafter, a laminate was produced in the same manner as in Example 17, and the same evaluation was carried out. The evaluation results are presented in Table 2.

### Example 20

A surface treated aromatic polyimide film was produced using an aromatic polyimide film (Ube Industries, Ltd., Upilex S25, thickness 25 µm) instead of the polyester film used in Example 17. Thereafter, a laminate was produced in the same manner as in Example 17, and the same evaluation was carried out. The evaluation results are presented in Table 2.

### Example 21

A surface treated aromatic polycarbonate film was produced using an aromatic polycarbonate film (Sumitomo Bakelite Co., Ltd., Polyca Ace ECK100, thickness 2 mm) instead of the polyester film used in Example 17. Thereafter, a laminate was produced in the same manner as in Example 17, and the same evaluation was carried out. The evaluation results are presented in Table 2.

### Example 22

A polypropylene film was produced (thickness 0.8 mm) by hot pressing a polypropylene (Japan Polypropylene Corp., Novatec PPMA3) at 200°C and 12 kg/cm² for 5 minutes. The polypropylene film was treated (300 W, 1 second) by using a corona treatment machine (AGF-B10S, manufactured by Kasuga Electric Works, Ltd.), and thus a corona-treated polypropylene film was obtained. The corona-treated polypropylene film was used instead of the polyester film used in Example 17. Thereafter, a laminate was produced in the same manner as in Example 17, and the same evaluation was carried out. The evaluation results are presented in Table 2.

### Example 23

### (Production of surface treated PET film)

98 g of deionized water, and 2.5 g of a oxazoline group-containing polymer solution (Nippon Shokubai Co., Ltd., EPOCROS WS-500, solids content 39 wt%) were mixed and dissolved. The solution thus obtained was applied on one surface of a polyethylene terephthalate film (Teijin Tetoron Film O3: thickness 50 µm) to a thickness of 30 µm by using an applicator (thickness after drying 0.3 µm). The solution was dried, and then the other surface was subjected to the same treatment and dried. This polyester film was heat treated at 100°C for 30 minutes. Thus, a surface treated PET film-36 was obtained.

### (Production of laminate)

The PVB film-1, the surface treated PET film-36, and the PVB film-1 were superimposed in this order, and the films were adhered by hot pressing at 135°C and 12 kg/cm² for 30 minutes. Thus, an intermediate film for laminated glass was obtained (total thickness 850 µm).

### (Production of laminated glass)

A transparent silicon glass, the intermediate film for laminated glass, and a transparent silicon glass were superimposed in this order, and this assembly was introduced into a rubber bag. The pressure inside the rubber bag was reduced to 0.01 kg/cm², and the assembly was treated at 100°C to pre-adhere the assembly. The pre-adhesion product thus obtained was pressed for 20 minutes under the conditions of 140°C and 12 kg/cm² in an autoclave, and thus a laminated glass was obtained.

### Example 24

A glass substrate having a thickness of 3 mm, the PVB film-1, a silicon power generating element, the PVB film-1, and the surface treated PET film-1 were superimposed, and the assembly was heated by using a vacuum laminator under the conditions of a hot plate temperature of 150°C, a degassing time of 1.5 minutes, a press pressure of 1 kg/cm², and a pressing time of 5 minutes, to seal the silicon power generating element. Thus, a solar cell module was obtained.

### Example 25

10 g of PVB-1 was dissolved in 190 g of ethanol to prepare a 5% PVB-ethanol solution. Subsequently, a mold form having the surface treated PET film-31 at the bottom side, and a size of 10 cm in length, 10 cm in width and 2 cm in height was produced. 20 g of the 5% PVB-ethanol solution was poured into the mold form, the solution was dried at room temperature, and thus a laminate was produced. The laminate thus obtained was evaluated in the same manner as in Example 17. The evaluation results are presented in Table 2.

### Example 26

### (Production of polyvinyl acetal film containing polymer having oxazoline group)

6 g of PVB-1, 2.7 g of a plasticizer (triethylene glycol di-2-ethylhexanoate, and 0.13 g of an oxazoline group-containing polymer solution (Nippon Shokubai Co., Ltd., EPOCROS WS-500, solids content 39 wt%) were dissolved in 60 g of ethanol. The solution was cast and dried, and thus a polyvinyl acetal film (PVB film) containing an oxazoline group-containing polymer was obtained.

### (Production of laminate)

One sheet of the PVB film-1 and one sheet of a PET film (Teijin Tetoron Film O3: thickness 50 µm) were superimposed, and the assembly was adhered by hot pressing at 135°C and 12 kg/cm² for 30 minutes. Thus, a laminate was obtained (total thickness 450 µm). An evaluation was carried out in the same manner as in Example 17, using the laminate. The evaluation results are presented in Table 2.

### Example 27

10 g of PVB-1 and 0.3 g of an oxazoline group-containing polymer solution (Nippon Shokubai Co., Ltd., EPOCROS WS-500, solids content 39 wt%) were dissolved in 190 g of ethanol to obtain a 5% PVB-ethanol solution. Subsequently, a mold form having a PET film (Teijin Tetoron Film O3: thickness 50 µm) as the bottom side, and a size of 10 cm in length, 10 cm in width and 2 cm in height was produced. 20 g of the 5% PVB-ethanol solution was poured into the mold form, the solution was dried at room temperature, and thus a laminate was produced. The laminate thus obtained was evaluated in the same manner as in Example 17. The evaluation results are presented in Table 2.

### Example 28

200 g of isopropanol was introduced into a 1-L separable flask, nitrogen was blown into the flask to form a nitrogen atmosphere inside the container, and then the container was heated to 60°C. 200 g of a 5% aqueous solution of 2,2'-azobis(2-amidinopropane) dihydrochloride was added thereto all at the same time, and then a monomer mixture composed of 50 g of ethyl acrylate, 70 g of methyl methacrylate, 20 g of 2-hydroxyethyl acrylate, and 60 g of 2-isopropenyl-2-oxazoline, was added dropwise to the flask over 3 hours using a dropping funnel. After completion of the dropwise addition, the reaction solution temperature was raised to 70°C over 20 minutes, and the reaction solution was allowed to react for 5 hours so that the entire amount of the added monomers was consumed by the reaction. After completion of the reaction, the solution was cooled to room temperature, and an appropriate amount of 25% aqueous ammonia was added thereto to adjust the pH of the solution to 8.0. Thus, a solution containing a polymer having an oxazoline group, with a non-volatile content of 38% by mass (the polymer having an oxazoline group, which is contained in this solution, is designated as polymer-41) was obtained.

### (Measurement of oxazoline group content of polymer-41)

The solvent of the solution containing the polymer having an oxazoline group was distilled off under reduced pressure, and thus a polymer-41 was obtained. 2 g of the polymer-41 was weighed in an Erlenmeyer flask, and 2 g of cyclohexanone was added thereto to swell the polymer. 2 g of propionic acid was further added, and the mixture was treated at 120°C for one hour and then cooled to room temperature. 30 mL of chloroform, 30 mL of deionized water, and an appropriate amount of phenolphthalein were added, and the resulting mixture was titrated with a 1 mol/L aqueous solution of sodium hydroxide to determine the oxazoline group content, which was found to be 2.6 mmol in 1 g of the polymer. A surface treated PET film-41 was produced using a solution containing the polymer-41 instead of the oxazoline group-containing solution used in Example 17. Thereafter, a laminate was produced in the same manner as in Example 17, and the same evaluation was performed. The evaluation results are presented in Table 2.

**[Table 2]**

| | Layer A | Layer B | Adhesive compound | | Peel stress [N/cm] | ΔYI |
|---|---|---|---|---|---|---|
| Example 17 | PVB-1/Plasticizer | Polyester | WS-500 | Layer C | 12.3 | 5.1 |
| Example 18 | PVB-1/Plasticizer | Polyester | WS-700 | Layer C | 13.2 | 4.7 |
| Example 19 | PVB-1/Plasticizer | Polymethyl methacrylate | WS-500 | Layer C | 8.3 | 4.5 |
| Example 20 | PVB-1/Plasticizer | Aromatic polyimide | WS-500 | Layer C | 14.5 | - |
| Example 21 | PVB-1/Plasticizer | Aromatic polycarbonate | WS-500 | Layer C | 9.0 | 5.0 |
| Example 22 | PVB-1/Plasticizer | Corona-treated polypropylene | WS-500 | Layer C | 7.4 | 6.1 |
| Example 25 | PVB-1 | Polyester | WS-500 | Layer C | 19.7 | 4.0 |
| Example 26 | PVB-1/Plasticizer | Polyester | WS-500 | Added to Layer A | 15.0 | 4.9 |
| Example 27 | PVB-1 | Polyester | WS-500 | Added to Layer A | 16.3 | 6.6 |
| Example 28 | PVB-1/Plasticizer | Polyester | Polymer-41 | Layer C | 9.5 | 5.0 |

### Comparative Example 1

A laminate was produced in the same manner as in Example 4, except that the PET film was not subjected to a surface treatment, and the same evaluation was carried out. The evaluation results are presented in Table 3.

### Comparative Example 2

A laminate was produced in the same manner as in Example 7, except that the polymethyl methacrylate film was not subjected to a surface treatment, and the same evaluation was carried out. The evaluation results are presented in Table 3.

### Comparative Example 3

A laminate was produced in the same manner as in Example 8, except that the aromatic polyimide film was not subjected to a surface treatment, and the same evaluation was carried out. The evaluation results are presented in Table 3.

### Comparative Example 4

A laminate was produced in the same manner as in Example 9, except that the aromatic polycarbonate film was not subjected to a surface treatment, and the same evaluation was carried out. The evaluation results are presented in Table 3.

### Comparative Example 5

A laminate was produced in the same manner as in Example 10, except that the corona-treated polypropylene film was not subjected to a surface treatment, and the same evaluation was carried out. The evaluation results are presented in Table 3.

### Comparative example 6

A laminate was produced in the same manner as in Example 13, except that a PET film which was not surface treated was used instead of the surface treated PET film-4, and the same evaluation was carried out. The evaluation results are presented in Table 3.

### Comparative Example 7

Toluene and 1 g of 3-aminopropyltrimethoxysilane were mixed and dissolved. The solution thus obtained was applied on one surface of a polyethylene terephthalate film (Teijin Tetoron Film O3: thickness 50 µm) to a thickness of 30 µm by using an applicator (thickness after drying 0.3 µm). Toluene was dried, and thus a surface treated PET film-7' was obtained. A laminate was produced in the same manner as in Example 1 using the surface treated PET film-7' instead of the surface treated PET film-1, and the same evaluation was carried out. The evaluation results are presented in Table 3.

### Comparative Example 8

A laminate was produced in the same manner as in Example 1, except that 1 g of methyltrimethoxysilane was used instead of 0.5 g of 2-dimethylaminoethyl methacrylate and 0.5 g of methyltrimethoxysilane, and the same evaluation was carried out. The evaluation results are presented in Table 3.

### Comparative Example 9

A laminate was produced in the same manner as in Example 1, except that 1 g of 3-methacryloyloxypropyltrimethoxysilane was used instead of 0.5 g of 2-dimethylaminoethyl methacrylate and 0.5 g of methyltrimethoxysilane, and the same evaluation was carried out. The evaluation results are presented in Table 3.

**[Table 3]**

| | Layer A | Layer B | Adhesive compound | | Peel stress [N/cm] | ΔYI |
|---|---|---|---|---|---|---|
| Comparative example 1 | PVB-1/Plasticizer | Polyester | - | - | 2.1 | 5.7 |
| Comparative example 2 | PVB-1/Plasticizer | Polymethyl methacrylate | - | - | 1.9 | 4.9 |
| Comparative example 3 | PVB-1/Plasticizer | Aromatic polyimide | - | - | 1.3 | - |
| Comparative example 4 | PVB-1/Plasticizer | Aromatic polycarbonate | - | - | 2.4 | 6.0 |
| Comparative example 5 | PVB-1/Plasticizer | Corona-treated polypropylene | - | - | 2.1 | 4.9 |
| Comparative example 6 | PVB-1 | Polyester | - | - | 2.1 | 7.0 |
| Comparative example 7 | PVB-1/Plasticizer | Polyester | *7 | Layer C | 10.5 | 34.9 |
| Comparative example 8 | PVB-1/Plasticizer | Polyester | *8 | Layer C | 3.8 | 4.8 |
| Comparative example 9 | PVB-1/Plasticizer | Polyester | *9 | Layer C | 3.9 | 4.8 |

| | | | | | | |
|---|---|---|---|---|---|---|
| *7: 3-Aminopropyltrimethoxysilane *8: Methyltrimethoxysilane *9: Polymer of 3-methacryloxypropyltrimethoxysilane | | | | | | |

### Example 29

160 g of methanol was introduced into a 1-L separable flask, nitrogen was blown into the flask to form a nitrogen atmosphere inside the container, and then the container was heated to 60°C. 200 g of a 5% aqueous solution of 2,2'-azobis(2-amidinopropane) dihydrochloride was added thereto all at the same time, and then 40 g of 3-methacryloyloxypropyltrimethoxysilane was added dropwise to the flask over 3 hours using a dropping funnel. After completion of the dropwise addition, the reaction solution temperature was raised to 70°C over 20 minutes, and the reaction solution was allowed to react for 3 hours so that the entire amount of the added monomers was consumed by the reaction. After completion of the reaction, the solution was cooled to room temperature, and an appropriate amount of 25% aqueous ammonia was added thereto to adjust the pH of the solution to 8.0. Thus, a solution containing a polymer with a non-volatile content of 10% by mass (the polymer contained in this solution is designated as polymer-42) was obtained.

A laminate was produced in the same manner as in Example 14, except that 1 g of the solution containing the polymer-42 was used instead of 0.4 g of butyltrimethoxysilane used in Example 14, and the same evaluation was carried out. The evaluation results are presented in Table 1.

### Example 30

160 g of methanol was introduced into a 1-L separable flask, nitrogen was blown into the flask to form a nitrogen atmosphere inside the container, and then the container was heated to 60°C. 200 g of a 5% aqueous solution of 2,2'-azobis(2-amidinopropane) dihydrochloride was added thereto all at the same time, and then a mixture of 32 g of 2-dimethylaminoethyl methacrylate and 8 g of 3-methacryloyloxypropyltrimethoxysilane was added dropwise to the flask over 3 hours using a dropping funnel. After completion of the dropwise addition, the reaction solution temperature was raised to 70°C over 20 minutes, and the reaction solution was allowed to react for 3 hours so that the entire amount of the added monomers was consumed by the reaction. After completion of the reaction, the solution was cooled to room temperature, and an appropriate amount of 25% aqueous ammonia was added thereto to adjust the pH of the solution to 8.0. Thus, a solution containing a polymer with a non-volatile content of 10% by mass (the polymer contained in this solution is designated as polymer-43) was obtained.

A laminate was produced in the same manner as in Example 14, except that 1 g of the solution containing the polymer-43 was used instead of 0.4 g of the tertiary amino group-containing polymer synthesized in Example 6 and 0.4 g of butyltrimethoxysilane used in Example 14, and the same evaluation was carried out. The evaluation results are presented in Table 1.

### INDUSTRIAL APPLICABILITY

The laminate of the present invention is excellent in interlayer adhesiveness, strength and transparency, and undergoes less deterioration in the weather resistance during a long-term use. Therefore, the laminate of the present invention is suitably used in intermediate film for laminated glass and solar cell modules.

### EXPLANATIONS OF REFERENCE NUMERALS

- 1: GLASS, LAMINATE RESIN SHEET, SINGLE LAYER RESIN SHEET
- 2: SEALANT
- 3: CRYSTALLINE SILICON

## Claims

1. A laminate which comprises a polyvinyl acetal layer (layer A) and a resin layer (layer B), the laminate comprising an adhesive layer (layer C) containing a polymer having an amino group between the layer A and the layer B, wherein the layer C contains
a polymer of a compound having a tertiary amino group and an ethylenically unsaturated bond, and a compound having an alkoxysilyl group,
a polymer of a compound having a tertiary amino group and an ethylenically unsaturated bond, and a polymer of a compound having an alkoxysilyl group and an ethylenically unsaturated bond,
a copolymer of a compound having a tertiary amino group and an ethylenically unsaturated bond and a compound having an alkoxysilyl group and an ethylenically unsaturated bond, or
a polymer having an oxazoline group.

2. A laminate which comprises a polyvinyl acetal layer (layer A) and a resin layer (layer B), wherein at least one of the layer A and the layer B contains a polymer having an amino group, and at least one of the layer A and the layer B contains
a polymer of a compound having a tertiary amino group and an ethylenically unsaturated bond, and a compound having an alkoxysilyl group,
a polymer of a compound having a tertiary amino group and an ethylenically unsaturated bond, and a polymer of a compound having an alkoxysilyl group and an ethylenically unsaturated bond,
a copolymer of a compound having a tertiary amino group and an ethylenically unsaturated bond and a compound having an alkoxysilyl group and an ethylenically unsaturated bond, or
a polymer having an oxazoline group.

3. The laminate according to Claim 1 or 2, wherein the ethylenically unsaturated bond is a group selected from the family consisting of an acryloyl group which may be substituted with a hydrocarbon substituent having 1 to 10 carbon atoms, and a vinyl group which may be substituted with a hydrocarbon substituent having 1 to 10 carbon atoms.

4. The laminate according to any one of the claims 1 to 3, wherein the resin layer (layer B) is a layer containing a resin which has any one of a carboxyl group, a phenolic hydroxyl group, an ester bond, an imide bond, and a carbonate bond.

5. The laminate according to any one of the claims 1 to 4, wherein the resin layer (layer B) is a layer containing at least one layer selected from the family consisting of a polyester, a polyunsaturated carboxylic acid ester, an aromatic polyimide, and an aromatic polycarbonate.

6. The laminate according to any one of the claims 1 to 5, wherein the resin layer (layer B) is a resin layer which has been subjected to a discharge treatment.

7. The laminate according to any one of claims 1 to 6, wherein the polyvinyl acetal layer (layer A) contains a plasticizer.

8. An intermediate film for laminated glass, comprising the laminate according to claim 7.

9. A laminated glass having the intermediate film for laminated glass according to claim 8.

10. A solar cell module comprising the laminate according to any one of the claims 1 to 7.

## Patentansprüche

1. Laminat, das eine Polyvinylacetalschicht (Schicht A) und eine Harzschicht (Schicht B) umfasst, wobei das Laminat eine Klebeschicht (Schicht C), die ein Polymer mit einer Aminogruppe enthält, zwischen der Schicht A und der Schicht B umfasst, wobei die Schicht C umfasst:
ein Polymer einer Verbindung mit einer tertiären Aminogruppe und einer ethylenisch ungesättigten Bindung, und eine Verbindung mit einer Alkoxysilylgruppe,
ein Polymer einer Verbindung mit einer tertiären Aminogruppe und einer ethylenisch ungesättigten Bindung, und ein Polymer einer Verbindung mit einer Alkoxysilylgruppe und einer ethylenisch ungesättigten Bindung,
ein Copolymer einer Verbindung mit einer tertiären Aminogruppe und einer ethylenisch ungesättigten Bindung und einer Verbindung mit einer Alkoxysilylgruppe und einer ethylenisch ungesättigten Bindung, oder
ein Polymer mit einer Oxazolingruppe.

2. Laminat, das eine Polyvinylacetalschicht (Schicht A) und eine Harzschicht (Schicht B) umfasst, wobei mindestens eine Schicht, ausgewählt aus der Schicht A und der Schicht B, ein Polymer mit einer Aminogruppe umfasst, und mindestens eine Schicht, ausgewählt aus der Schicht A und der Schicht B, umfasst:
ein Polymer einer Verbindung mit einer tertiären Aminogruppe und einer ethylenisch ungesättigten Bindung, und eine Verbindung mit einer Alkoxysilylgruppe,
ein Polymer einer Verbindung mit einer tertiären Aminogruppe und einer ethylenisch ungesättigten Bindung, und ein Polymer einer Verbindung mit einer Alkoxysilylgruppe und einer ethylenisch ungesättigten Bindung,
ein Copolymer einer Verbindung mit einer tertiären Aminogruppe und einer ethylenisch ungesättigten Bindung und einer Verbindung mit einer Alkoxysilylgruppe und einer ethylenisch ungesättigten Bindung, oder
ein Polymer mit einer Oxazolingruppe.

3. Laminat gemäß Anspruch 1 oder 2, wobei die ethylenisch ungesättigte Bindung eine Gruppe ist, die ausgewählt ist aus der Familie bestehend aus einer Acrylgruppe, die mit einem Kohlenwasserstoffsubstituent mit 1 bis 10 Kohlenstoffatomen substituiert sein kann, und einer Vinylgruppe, die mit einem Kohlenwasserstoffsubstituent mit 1 bis 10 Kohlenstoffatomen substituiert sein kann.

4. Laminat gemäß einem der Ansprüche 1 bis 3, wobei die Harzschicht (Schicht B) eine Schicht ist, die ein Harz umfasst, das irgendeines einer Carboxylgruppe, einer phenolischen Hydroxylgruppe, einer Esterbindung, einer Imidbindung, und einer Carbonatbindung aufweist.

5. Laminat gemäß einem der Ansprüche 1 bis 4, wobei die Harzschicht (Schicht B) eine Schicht ist, die mindestens eine Schicht umfasst, die ausgewählt ist aus der Familie bestehend aus einem Polyester, einem Polymer eines ungesättigten Carbonsäureesters, einem aromatischen Polyimid, und einem aromatischen Polycarbonat.

6. Laminat gemäß einem der Ansprüche 1 bis 5, wobei die Harzschicht (Schicht B) eine Harzschicht ist, die einer Entladungsbehandlung unterzogen wurde.

7. Laminat gemäß einem der Ansprüche 1 bis 6, wobei die Polyvinylacetalschicht (Schicht A) einen Weichmacher umfasst.

8. Intermediäre Folie für laminiertes Glas, die das Laminat gemäß Anspruch 7 umfasst.

9. Laminiertes Glas mit der intermediären Folie für laminiertes Glas gemäß Anspruch 8.

10. Solarzellenmodul, welches das Laminat gemäß einem der Ansprüche 1 bis 7 umfasst.

## Revendications

1. Stratifié qui comprend une couche d'acétal de polyvinyle (couche A) et une couche de résine (couche B), le stratifié comprenant une couche adhésive (couche C) contenant un polymère ayant un groupe amino entre la couche A et la couche B, dans lequel la couche C contient
un polymère d'un composé ayant un groupe amino tertiaire et une liaison éthyléniquement insaturée, et un composé ayant un groupe alcoxysilyle,
un polymère d'un composé ayant un groupe amino tertiaire et une liaison éthyléniquement insaturée, et un polymère d'un composé ayant un groupe alcoxysilyle et une liaison éthyléniquement insaturée,
un copolymère d'un composé ayant un groupe amino tertiaire et une liaison éthyléniquement insaturée et un composé ayant un groupe alcoxysilyle et une liaison éthyléniquement insaturée, ou
un polymère ayant un groupe oxazoline.

2. Stratifié qui comprend une couche d'acétal de polyvinyle (couche A) et une couche de résine (couche B), dans lequel au moins une parmi la couche A et la couche B contient un polymère ayant un groupe amino, et au moins une parmi la couche A et la couche B contient
un polymère d'un composé ayant un groupe amino tertiaire et une liaison éthyléniquement insaturée, et un composé ayant un groupe alcoxysilyle,
un polymère d'un composé ayant un groupe amino tertiaire et une liaison éthyléniquement insaturée, et un polymère d'un composé ayant un groupe alcoxysilyle et une liaison éthyléniquement insaturée,
un copolymère d'un composé ayant un groupe amino tertiaire et une liaison éthyléniquement insaturée et un composé ayant un groupe alcoxysilyle et une liaison éthyléniquement insaturée, ou
un polymère ayant un groupe oxazoline.

3. Stratifié selon la revendication 1 ou 2, dans lequel la liaison éthyléniquement insaturée est un groupe choisi dans la famille constituée d'un groupe acryloyle qui peut être substitué par un substituant hydrocarboné ayant 1 à 10 atomes de carbone, et d'un groupe vinyle qui peut être substitué par un substituant hydrocarboné ayant 1 à 10 atomes de carbone.

4. Stratifié selon l'une quelconque des revendications 1 à 3, dans lequel la couche de résine (couche B) est une couche contenant une résine qui possède l'un quelconque d'un groupe carboxyle, d'un groupe hydroxyle phénolique, d'une liaison ester, d'une liaison imide, et d'une liaison carbonate.

5. Stratifié selon l'une quelconque des revendications 1 à 4, dans lequel la couche de résine (couche B) est une couche contenant au moins une couche choisie dans la famille consistant en un polyester, un ester d'acide carboxylique poly-insaturé, un polyimide aromatique, et un polycarbonate aromatique.

6. Stratifié selon l'une quelconque des revendications 1 à 5, dans lequel la couche de résine (couche B) est une couche de résine qui a été soumise à un traitement par décharge.

7. Stratifié selon l'une quelconque des revendications 1 à 6, dans lequel la couche d'acétal de polyvinyle (couche A) contient un plastifiant.

8. Film intermédiaire pour verre stratifié, comprenant le stratifié selon la revendication 7.

9. Verre Stratifié ayant le film intermédiaire pour verre stratifié selon la revendication 8.

10. Module de cellule solaire comprenant le stratifié selon l'une quelconque des revendications 1 à 7.
